# EUROPÄISCHE PATENTSCHRIFT

(11) **EP 3 667 243 B1**
(45) Veröffentlichungstag und Bekanntmachung des Hinweises auf die Patenterteilung: **11.09.2024**
(21) Anmeldenummer: 19213381.7
(22) Anmeldetag: 04.12.2019
(51) Int. Cl.: G01D 4/00, G01D 9/00, G01D 21/00, H04Q 9/00, H04W 56/00, H04W 4/38

(54) **VERFAHREN ZUM SAMMELN VON DATEN SOWIE SENSOR UND MESSDATEN-INFORMATIONSNETZWERK**
METHOD FOR COLLECTING DATA, SENSOR AND MEASURING DATA INFORMATION NETWORK
PROCÉDÉ DE COLLECTE DES DONNÉES AINSI QUE CAPTEUR ET RÉSEAU D'INFORMATIONS DE DONNÉES DE MESURE

(30) Priorität: 14.12.2018 DE 102018009821
(43) Veröffentlichungstag der Anmeldung: 17.06.2020
(73) Patentinhaber: Diehl Metering Systems GmbH, 90451 Nürnberg (DE); DIEHL METERING SAS, 68304 Saint Louis (FR)
(72) Erfinder: Joppich-Dohlus, Petra, 91080 Rathsberg (DE); Kauppert, Thomas, 90455 Nürnberg (DE); Schmidt, Achim, 91367 Weißenohe (DE); Schmitz, Stefan, 90455 Nürnberg (DE); Sosna, Christoph, 90429 Nürnberg (DE); Bach, Guy, 68640 Waldighofen (FR); Breton, Aster, 05350 Saint Véran (FR); Gottschalk, Klaus, 90610 Winkelhaid (DE)
(74) Vertreter: Diehl Patentabteilung

(56) Entgegenhaltungen:
- US-A1- 2013 254 881
- US-A1- 2013 285 834

## Beschreibung

Die vorliegende Erfindung betrifft zum einen ein Verfahren zum Sammeln von Daten gemäß Anspruch 1, einen Sensor gemäß Anspruch 21 sowie ein Messdaten-Informationsnetzwerk gemäß Anspruch 22.

### Technologischer Hintergrund

Verbrauchszähler sind Bestandteil von Versorgungsnetzen zur Verteilung von Verbrauchsgütern, wie z.B. Gas, Wasser, Wärme oder Elektrizität, und dienen dazu Verbrauchsdaten zu generieren. Verbrauchsdaten werden auf der Basis von von einem Messelement eines Sensors gelieferten Rohmessdaten von einem zählerseitigen Mikroprozessor errechnet und über ein Kommunikationssystem in Form eines BUS-Systems, insbesondere eines sogenannten M-BUS-Systems über Funk oder Draht, d. h. wireless oder wired M-BUS an einen Datenkonzentrator gesendet. Der Datenkonzentrator leitet die Daten über ein vom M-BUS verschiedenes System an eine zentrale Datenverwaltung (Head-End-System) weiter. Bei den Daten handelt es sich vor allem um den aktuellen Verbrauch, d.h. den Zählerstand.

Hierbei werden Rohmessdaten von dem Messelement eines Sensors des Verbrauchszählers zu vorbestimmten vorgegebenen Zeitpunkten generiert, von einem Mikroprozessor des Verbrauchszählers ausgewertet d. h. in Verbrauchsdaten umgerechnet und die daraus resultierenden Verbrauchsdaten anschließend über eine primäre Kommunikationsstrecke von einer Lese- bzw. Empfangseinrichtung (M-BUS-Master bzw. Konzentrator oder Datensammler) zu festgelegten Zeitpunkten an den einzelnen lokal angeordneten Verbrauchszähler abgefragt.

Anschließend werden die Verbrauchsdaten von der Lese- bzw. Empfangseinrichtung über eine tertiäre Kommunikationsstrecke, beispielsweise auf Basis von LAN, GPRS, 3G, LTE, weiter zu einem Head-End-System übertragen. Die Verbrauchsdaten können dann im Head-End angezeigt oder zur Rechnungsstellung verwendet werden. Die bisherige Konzeption der Verbrauchsdatenerfassung ist sowohl in ihrer Informationstiefe als auch in ihrem Informationsumfang begrenzt.

### Druckschriftlicher Stand der Technik

Die US 2013/285834 A1 beschreibt ein Verfahren zum Erhalt von genauen, momentanen elektrischen Verbrauchsdaten für Telemetrie Zwecke. Die Daten sollen innerhalb einiger weniger Sekunden mit hoher Auflösung übertragen werden. Pulse werden zusammen mit einem Zeitstempel übertragen, wobei der jeweiligen Puls-bezogene Zeitstempel an dem nachziehenden Ende des jeweiligen Pulses erzeugt wird. Die Übertragung der mit Zeitstempel versehenen Pulse soll permanent in einem fest vorgegebenen Zeitraster von wenigen Sekunden erfolgen.

In der US 2013/0254881 A1 wird eine Methode zur Erkennung von Datenverfälschungen beschrieben, welche die ständige Erfassung von Rohmessdaten in einer Sensoreinheit umfasst. Die Rohmessdaten eines definierten Zeitintervalls werden in einer Metrologie-Einheit verarbeitet, um erste Messergebnisse zu erhalten. Die ersten Messergebnisse werden zu definierten Zeitpunkten über einen Kommunikationskanal an eine Behörde übermittelt. Ein definierter Anteil der Rohmessdaten wird über den Kommunikationskanal in zufälliger Weise an die Behörde übertragen. Die Rohmessdaten des definierten Zeitintervalls werden bei der Behörde verarbeitet, um zweite Messergebnisse zu erhalten, wobei die ersten und zweiten Messergebnisse eines Zeitintervalls verglichen werden.

### Aufgabe der vorliegenden Erfindung

Die Aufgabe der vorliegenden Erfindung besteht darin, ein gattungsgemäßes Verfahren zum Sammeln und/oder Weiterleiten von Daten sowie einen hierfür einzusetzenden Sensor jeweils mit gesteigertem Informationsinhalt zur Verfügung zu stellen.

### Lösung der Aufgabe

Die vorstehende Aufgabe wird durch die Merkmale des Anspruchs 1 gelöst, durch einen Sensor gemäß Anspruch 21 sowie durch ein Messdaten-Informationsnetzwerk gemäß Anspruch 22. Zweckmäßige Ausgestaltungen des erfindungsgemäßen Verfahrens werden in den Unteransprüchen beansprucht. Erfindungsgemäß ist ein Verfahren zum Sammeln von Daten vorgesehen, vorzugsweise Daten in Zusammenhang mit einem Verbrauch, einem physikalischen oder physikalisch-chemischen Parameter und/oder einem Betriebszustand im Rahmen eines Betriebs eines lokalen Sensors, vorzugsweise eines Sensors für einen Verbrauchszähler, als Bestandteil eines mindestens einen lokalen Sensor vorzugsweise eine Mehrzahl von lokalen Sensoren umfassendes Versorgungsnetzes zur Verteilung eines Verbrauchsguts, wobei der Sensor ein Messelement enthält, das Messelement des jeweiligen Sensors elementare Messeinheiten, die mindestens einer physikalischen oder physikalisch-chemischen Größe oder mindestens eines physikalischen oder physikalisch-chemischen Parameters entsprechen, als Rohmessdaten liefert, Verbrauchsdaten aus den elementaren Messeinheiten erzeugt werden und der Sensor Kommunikationsmittel sowie Speichermittel umfasst, dadurch gekennzeichnet, dass zur Festlegung der Messauflösung des Sensors die Bedingungen für ein Generieren von Zeitstempelungen unter Anwendung eines Korrelierungsmodells vorher festgelegt werden, auf der Basis des Korrelierungsmodells Zeitstempelungen von aufeinanderfolgenden Rohmessdaten in dem Sensor generiert werden, die Zeitstempelungen über eine drahtgebundene Verbindung und/oder über eine Funkstrecke übertragen werden, so dass auf Basis der Zeitstempelungen unter Anwendung des Korrelierungsmodells die vom Messelement erfassten Rohmessdaten rekonstruiert und ausgewertet werden, wobei die Verbrauchsdaten parallel zu den Zeitstempelungen übertragen werden.

Erfindungsgemäß werden zur Festlegung der Messauflösung des Sensors die Bedingungen für ein Generieren von Zeitstempelungen unter Anwendung eines Korrelierungsmodells vorher festgelegt. Auf der Basis des Korrelierungsmodells werden Zeitstempelungen von aufeinanderfolgenden Rohmessdaten in dem Sensor generiert und in den Speichermitteln abgelegt. Anschließend werden lediglich die den erfassten Rohmessdaten zugeordneten Zeitstempelungen über die primäre Kommunikationsstrecke übertragen, so dass auf Basis der bei dem Master ankommenden Zeitstempelungen unter Anwendung des Korrelierungsmodells die vom Messelement erfassten Rohmessdaten nach erfolgter Übertragung wieder rekonstruiert und ausgewertet werden können. Hierdurch entfallen rechenaufwendige und deshalb energieintensive Rechenoperationen im Bereich des lokalen Sensors. Rechenaufwendige und energieintensive Rechenoperationen können somit in den Bereich des Masters oder eines Head-Ends verlagert werden. Das erfindungsgemäße Verfahren ermöglicht es, Zeitstempelungen von Rohmessdaten in einem fortlaufenden, vollständigen und konsistenten Zeitzusammenhang, also lückenlos, insbesondere im Bereich einer entfernten zentralen Verarbeitungsanlage bzw. einem Head-End-System bereitzustellen. Die aus den Zeitstempelungen rekonstruierten Rohmessdaten können dem Zeitverlauf kontinuierlich zugeordnet werden, d.h. bilden einen Realzeit-Verlauf ab, der diskontinuierliche Lücken oder Datenfehlzeiten ausschließt. Der gemäß dem erfindungsgemäßen Verfahren im Head-End erzeugte kontinuierliche Rohmessdatenstrom besitzt im Vergleich zu bisherigen Lösungen eine sehr viel höhere Auflösung über der kontinuierlichen Zeitachse. Die Erfindung ermöglicht es, neben z. B. einer Verbrauchsberechnung eine viel größere Anzahl von Berechnungen und/oder Feststellungen und/oder Funktionen einschließlich "Business"-Funktionen beispielsweise im Head-End-System vornehmen zu können, als dies bisher möglich war. Aufgrund des erfindungsgemäßen Verfahrens kann zudem der Aufbau des Sensors wesentlich einfacher und kostengünstiger sein, da komplexe Mikroprozessoren für Berechnungen, wie z. B. zur Berechnung der Durchflussmenge, wegfallen. Aufgrund des erfassten zeitlichen Zusammenhangs der Rohmessdaten können Manipulationen vermieden werden, da die Messergebnisse über deren gesamten zeitlichen Verlauf mit empirischen Werten über die gesamte Zeitachse verglichen werden können. Ferner ist der Energieverbrauch der Baugruppe aus Sensor und der Zeitstempelaufbereitung bzw. den Kommunikationsmitteln wegen des Wegfalls von energieintensiver Rechenleistung wesentlich geringer als bei bisherigen Ausführungen, welche die Daten lokal auswerten. Bei den Zeitstempelungen kann es sich um Zeitpunkte oder Zeitdifferenzen handeln. Die Zeitpunkte oder Zeitdifferenzen können Ist-Zeitdaten oder Realzeitdaten sein oder zumindest daran orientiert sein. Die Zeitdifferenzen können von Zeitstempelung zu Zeitstempelung und/oder von einem fest vorgegebenen Zeitpunkt aus gebildet sein.

Das erfindungsgemäße Verfahren hat den Vorteil, dass die Übertragung und Auswertung der Zeitstempelungen robuster gegenüber möglichen Verlusten in der Übertragung der Zeitstempelungen wird. So kann es z. B. zu einer Störung in der Funkübertragung kommen, was zu einem Verlust von Zeitstempelungen führt. Durch das parallele Senden von Zeitstempelungen und Verbrauchsdaten können vorteilhafterweise Ausfälle kompensiert werden.

Erfindungsgemäß stehen der oder die lokalen Sensoren über eine primäre Kommunikationsstrecke mit einem Datensammler in Verbindung stehen, ist zwischen dem Datensammler und einem Head-End eine tertiäre Kommunikationsstrecke vorgesehen und werden die von Sensoren und/oder von Verbrauchszählern übertragenen Zeitstempelungen im Datensammler und/oder im Head-End gesammelt, gespeichert und/oder ausgewertet. Es handelt sich hierbei um ein automatisches Zählerfernauslese-System in einem Festnetz (fixed network automatic meter reading). Die Übertragung der Zeitstempelungen über die primäre und tertiäre Kommunikationsstrecke ermöglicht es, eine erheblich größere Anzahl von Berechnungen und/oder Feststellungen und/oder Funktionen einschließlich "Business"-Funktionen im Head-End, wo genügend Rechenleistung zur Verfügung steht, vornehmen zu können als bisher.

Bei dem Korrelierungsmodell kann ein bestimmter Wert oder eine bestimmte Wertänderung oder eine bestimmte Wertdifferenz der mindestens einen physikalischen oder physikalisch-chemischen Größe oder des mindestens einen physikalischen oder physikalisch-chemischen Parameters für die Zuordnung einer Zeitstempelung festgelegt werden, wobei bei einem Erfassen des bestimmten Werts oder der bestimmten Wertdifferenz oder der bestimmten Wertänderung durch das Messelement die Zeitstempelung ausgelöst, als solche in den Speichermitteln des Sensors abgespeichert und für die Übertragung bereitgestellt wird. Ändert sich der vom Sensor erfasste Wert nicht, wird keine Zeitstempelung erzeugt. Somit können typisch für das erfindungsgemäße Verfahren längere Zeiträume ohne Zeitstempelung verstreichen. Es müssen somit nicht ständig Daten übertragen werden. Dennoch besitzt das Verfahren eine sehr hohe Auflösung.

Insbesondere können im Rahmen des Korrelierungsmodells ein schrittweise oder inkrementell sich erhöhender Zählerstand und/oder eine Wertetabelle mittels Zeitstempelungen abgebildet werden.

Vorzugsweise sind die Zeitstempelungen mit einem Vorzeichen, z.B. Plus- oder Minusvorzeichen, versehen. Dies ist vor allem bei der Abbildung einer Wertetabelle von Vorteil, da hierdurch festgelegt wird, ob die konkrete Zeitstempelung einen aufsteigenden oder absteigenden Wert der Wertetabelle betrifft.

Gemäß der Erfindung werden eine Mehrzahl von Zeitstempelungen entlang der primären Kommunikationsstrecke jeweils als Datenpaket übertragen.

Vorteilhafterweise kann auf Basis der beim Datensammler und/oder beim Head-End ankommenden Zeitstempelungen unter Anwendung des Korrelierungsmodells ein Rohmessdatenstrom generiert werden. Bei den betreffenden aufeinanderfolgenden Zeitstempelungen handelt es sich insbesondere um keine Berechnungen und/oder Auswertungen.

Vorteilhafterweise können die Zeitstempelungen komprimiert werden und die Komprimierung der Zeitstempelungen verlustfrei durchgeführt werden. Die Komprimierung der Zeitstempelungen kann im Bereich des Sensors bzw. des Verbrauchszählers verlustfrei durchgeführt werden. Die Übertragung der Zeitstempelungen kann zweckmäßigerweise in komprimierter Form und/oder über eine Funkstrecke erfolgen. Die Übertragung kann wiederholt und bedingt jeweils nach Ablauf eines vorgegebenen Zeitintervalls und/oder nach Erreichen einer vorgegebenen Menge an Zeitstempelungen, die seit einer vorherigen Übertragung angesammelt wurden, durchgeführt werden. Beispielsweise können die Zeitstempelungen bei einem kontinuierlichen Fluss gleichmäßige zeitliche Abstände aufweisen. Hier besteht z. B. die Möglichkeit, die Zeitstempelungen mit gleichen Abständen zusammenzufassen und dadurch eine Komprimierung der Zeitstempelungen zu erreichen.

Alternativ kann die Komprimierung der Zeitstempelungen aber auch mit einem vorgegebenen, zulässigen Verlustniveau durchgeführt werden. Wird die Datenkomprimierung mit einem vorgegebenen zulässigen Verlustniveau durchgeführt, kann, wenn der Benutzer oder Betreiber eine Energieeinsparung bevorzugt und eine gewisse Ungenauigkeit bei der Wiederherstellung und Wiedergabe der ursprünglichen Messdaten akzeptiert (d.h. einen gewissen Verlust akzeptiert), das Komprimierungsverhältnis dann zum Nachteil einer geringeren Genauigkeit bei der Wiedergabe auf der Empfängerseite erhöht werden. Das Verlustverhältnis oder das Komprimierungsverhältnis kann als programmierbarer oder einstellbarer Parameter vorgesehen sein, der den Komprimierungsmodus bestimmt oder einstellt.

Als anschauliche und nicht beschränkende Beispiele für Datenkomprimierungsalgorithmen kann im Rahmen des erfindungsgemäßen Verfahrens in Betracht gezogen werden: eine differenzielle Komprimierung (Delta-Kodierung) in Verbindung mit einer Huffman-Kodierung, eine Lauflängenkodierung (RLE-Kodierung) oder vorzugsweise eine adaptive binäre arithmetische Kodierung (CABAC-Kodierung).

Zweckmäßigerweise können die Verbrauchsdaten nicht komprimiert werden. Da das Sendeintervall von Verbrauchsdaten größer ist als das von Zeitstempelungen, kann auf eine Komprimierung verzichtet werden.

Vorteilhafterweise können die Zeitstempelungen und die Verbrauchsdaten über verschiedene Funkstrecken übertragen werden. Um das Verfahren noch robuster zu machen, wird erfindungsgemäß das parallele Senden von Zeitstempelungen und Verbrauchsdaten über verschiedene Übertragungswege, wie beispielsweise unterschiedliche Funkstrecken vollzogen. Eine Störung in einer Funkstrecke hat somit keinen Einfluss auf die andere Funkstrecke, sodass wichtige Informationen aus einem Datensatz, also aus den Rohmessdaten oder aus den Verbrauchsdaten, rekonstruiert werden können. Ferner besteht die Möglichkeit, dass die jeweiligen Funkstrecken geändert werden, sodass eine bestimmte Funkstrecke nur für eine begrenzte Zeitspanne verwendet wird.

Zweckmäßigerweise können die Verbrauchsdaten an ein mobiles Auslesemodul gesendet werden und die Zeitstempelungen über eine primäre Kommunikationsstrecke an einen Datensammler gesendet werden. Die Ausleseintervalle mittels mobiler Auslesemodule sind größer als die über einen Datensammler in einem "fixed network". Die Verbrauchsdaten weisen eine geringere zeitliche Granularität also die Zeitstempelungen auf, so dass größere Ausleseintervalle möglich sind. Die verfügbare Bandbreite des "fixed network" kann somit vorteilhafterweise für die Übertragung der Zeitstempelungen verwendet werden.

Vorteilhafterweise können die Verbrauchsdaten und die Zeitstempelungen kombiniert werden. Die Kombination kann zweckmäßigerweise in einer entfernten zentralen Verarbeitungsanlage bzw. einem Head-End-System stattfinden. Beide Arten von Daten, also Verbrauchsdaten und Zeitstempelungen, können kombiniert werden, um sicherzustellen, dass immer alle notwendigen Informationen rechtzeitig zur Verfügung stehen. Im Fall einer gestörten Kommunikation können somit durch die Kombination der Daten, wichtige Verbrauchsdaten bestimmt und/oder rekonstruiert werden.

In einer Ausgestaltung können die, vorzugsweise komprimierten Zeitstempelungen im Head-End gespeichert werden und bei Bedarf (on-demand) dekomprimiert und ausgewertet werden. Hierbei werden die Zeitstempelungen im Head-End nicht sofort dekomprimiert und/oder ausgewertet, sondern gespeichert bzw. vorgehalten bis ein Bedarf für die Daten zu einem späteren Zeitpunkt besteht. Beispielsweise können bei einer Störung, einem Alarm, einem Fehler oder ähnlichem bei einem Verbrauchszähler die Zeitstempelungen dekomprimiert und ausgewertet werden, um detaillierte Informationen über den am Verbrauchszähler vorliegenden Zustand zu erhalten.

In einer weiteren Ausgestaltung können die Verbrauchsdaten verwendet werden, um fehlende und/oder fehlerhafte Zeitstempelungen zu kompensieren. Beispielsweise können durch eine Störung in der Übertragung vom Verbrauchszähler zum Head-End Zeitstempelungen fehlen oder fehlerhaft sein. Das Head-End kann die fehlenden und/oder fehlerhaften Zeitstempelungen nicht korrekt verarbeiten und auswerten. Vorteilhafterweise können die Verbrauchsdaten verwendet werden, um die fehlenden und/oder fehlerhaften Zeitstempelungen zu identifizieren oder die Verbrauchszählerfunktionen zurückzusetzen bzw. zu resetten. Die aktuellen Verbrauchsdaten können somit als Basiswert für nachfolgende Zeitstempelungen verwendet werden, um unter Anwendung des Korrelierungsmodells die vom Messelement erfassten Rohmessdaten zu rekonstruieren und auszuwerten.

Es besteht die Möglichkeit, dass die Verbrauchsdaten und die Zeitstempelungen verglichen werden, um eine Konsistenzkontrolle durchzuführen. Hierbei können die Verbrauchsdaten beispielsweise einen absoluten Zählerindex zu einem bestimmten Zeitpunkt umfassen, wie z. B. ein Fälligkeitsdatum, welches der Verbrauchszähler liefert. Andererseits können die Zeitstempelungen beispielsweise verwendet werden, um einen absoluten Zählerindex zu berechnen. Die Berechnung kann z. B. im Head-End stattfinden, so dass ein Fälligkeitsdatum, welches vom Head-End bereitgestellt wird, berechnet werden kann. Für eine Konsistenzkontrolle können diese beiden Werte verglichen werden. Damit die Verbrauchsdaten mit den Zeitstempelungen konsistent sind, müssen beispielsweise die absoluten Zählerindizes vom Verbrauchszähler und vom Head-End zu einem bestimmten Zeitpunkt identisch sein. Sofern die absoluten Zählerindizes nicht identisch sind, deutet dies auf eine Diskrepanz zwischen Verbrauchsdaten und Zeitstempelungen hin. Es können anschließend Maßnahmen ergriffen werden, um diese Diskrepanz zu korrigieren.

Vorzugsweise ist der rekonstruierte Rohmessdatenstrom in der Weiterfolge der Datenverarbeitung abgesehen von seiner zeitlichen Auflösung (Abtastrate oder Vielfaches der Abtastrate) jederzeit auf einer zeithistorischen Basis zeitlückenlos auswertbar. Daraus resultiert der Vorteil, dass z.B. auch in der Vergangenheit liegende ereignisbedingte Zustandsveränderungen im Versorgungsnetzwerk (wie z.B. Overflow, Underflow, Leckagen, Manipulationsversuche usw.) in genauer Zeitzuordnung und ohne Lücken feststellbar bzw. dokumentierbar sind. Durch eine hochgranulare zeitdiskrete Abtastung ist eine hohe Genauigkeit in der zeitlichen Auflösung gegeben. Ferner besteht die Möglichkeit, vergangene Verbrauchsdaten dem Verbraucher wesentlich genauer anzuzeigen und/oder bei Auswertungen hinsichtlich des Verbrauchsverhaltens bzw. Änderungen desselben besser miteinzubeziehen. Dies wiederum wirkt sich verbrauchsoptimierend aus und stellt für den Verbraucher eine besonders wichtige Information des Netzversorgers dar.

Beispielsweise kann es sich bei elementaren Messeinheiten um die elektrische Spannung oder um die Stromstärke handeln, die gemessen werden. Beispielsweise kann die Ausgangsspannung eines Hallsensors im Falle seiner Anregung oder die Spannung eines Temperaturfühlers erfasst werden. Zweckmäßigerweise kann sich die gemessene physikalische Größe auf ein Versorgungsmedium, vorzugsweise Wasser, Strom, Treibstoff oder Gas, eines Versorgungsnetzes beziehen.

Es besteht die Möglichkeit, dass der oder einer der gemessene(n) physikalische(n) oder chemisch-physikalische(n) Parameter kennzeichnend ist für die Menge, die Qualität und/oder Zusammensetzung eines Fluids, das durch den betreffenden Sensor strömt oder von diesem kontaktiert wird.

Die elementare Messeinheit kann zweckmäßigerweise eine Zeitstempelung generieren, sobald die elementare Messeinheit einen Impuls empfängt.

Es besteht die Möglichkeit, dass der Rohmessdatenstrom eine zeitliche Auflösung besitzt, die durch die Sensor-Abtastrate bzw. Messelement-Abtastrate oder ein Vielfaches derselben festgelegt oder bedingt ist. Zweckmäßigerweise besitzt der Rohmessdatenstrom eine zeitliche Auflösung, die nur durch die Sensor-Abtastrate bzw. Messelement-Abtastrate oder ein Vielfaches derselben festgelegt oder zumindest bedingt ist. Die zeitliche Auflösung des Rohmessdatenstroms liegt vorzugsweise im Sekundenbereich, Zehntelsekundenbereich, Hundertstelsekundenbereich oder Tausendstelsekundenbereich.

Vorteilhafterweise ist der Rohmessdatenstrom unter Zugrundelegung der festgelegten Auflösung kontinuierlich und/oder vollständig. Daraus resultiert eine ganz besonders hohe Messwertauflösung entlang des kontinuierlichen Zeitverlaufs und daraus wiederum eine besondere Informationstiefe als Basis für darauf aufbauende Auswertungen bzw. Berechnungen.

Um den kontinuierlichen Rohmessdatenstrom zu erzeugen, werden die Daten-Pakete zweckmäßigerweise in einer entsprechenden Zeitabfolge-Referenz zusammengefügt oder zumindest zueinander in Relation gesetzt, sodass die in den Paketen enthaltenen Zeitstempelungen entlang der Realzeitachse entsprechend ihrer Abtastung und vorherigen Paketaufteilung später wieder zusammengefügt oder zumindest in eine fortlaufende zeitliche Relation zueinander gesetzt sind.

Die Festlegung der Frage, wann eine neue Datenübertragung in Form einer Nachricht oder eines Telegramms (eines oder mehrerer Datenpakete) durchzuführen ist, hängt erfindungsgemäß davon ab, ob mindestens die Bedingung b) der beiden Bedingungen
(a) Ablauf eines vorgegebenen Zeitintervalls und
(b) Erreichen einer vorgegebenen Menge an insbesondere komprimierten gesammelten Zeitstempelungen seit der vorherigen Übertragung erfüllt ist. Aufgrund dessen kann eine Zeitabfolge-Referenz der zu übertragenden Daten-Pakete in einfacher Weise realisiert werden.

Besonders zweckmäßig ist, dass das Verfahren umfasst, die Zeitstempelungen durch Formatierung in Datenpaketen vorbestimmter fester Größe zu verpacken, wobei jedes Mal, wenn die akkumulierten Daten die Größe eines Datenpakets erreichen oder das vorgegebene Zeitintervall abgelaufen ist, eine neue Übertragung ausgelöst wird.

Es besteht die Möglichkeit, dass die Datenübertragung mit einer Redundanz durchgeführt wird. Zweckmäßigerweise kann die Redundanz in der Übertragung durch wiederholtes Senden desselben Datenpakets in mehreren aufeinanderfolgenden Übertragungsvorgängen oder auf unterschiedlichen Kommunikationswegen oder Funkkanälen erreicht werden. Es besteht ferner die Möglichkeit, dass die Redundanz in der Übertragung durch wiederholtes Senden derselben Zeitstempelungen erreicht wird. Beispielsweise kann die Übertragung eines Datenpakets oder einer Zeitstempelung fünf Mal wiederholt werden.

Nebengeordnet beansprucht die vorliegende Erfindung zudem einen Sensor, welcher hergerichtet ist für den lokalen Einsatz in einem eine Mehrzahl von lokalen Sensoren umfassenden Versorgungsnetz zur Verteilung eines Verbrauchsmediums, wie z.B. Wasser, Gas, Elektrizität, Treibstoff oder Wärme. Ein solcher Sensor kann Bestandteil eines Verbrauchszählers sein. Er ermöglicht es, im Rahmen des Betriebs eines Versorgungsnetzes den Verbrauch sowie weitere Zustandseigenschaften in sehr hoher Auflösung entlang des zeitlichen Verlaufs lückenlos und kontinuierlich zu gewährleisten.

Schließlich betrifft die vorliegende Erfindung zudem ein Messdaten-Informationsnetzwerk mit mindestens einem lokalen Sensor vorzugsweise einer Mehrzahl von lokalen Sensoren zum Generieren und/oder Weiterleiten von Zeitstempelungen aufgrund von Rohmessdaten auf der Basis des Korrelierungsmodells, vorzugsweise Rohmessdaten in Zusammenhang mit einem Verbrauch an Verbrauchsmedium und/oder einem Betriebszustand eines Verbrauchszählers, mit einem Datensammler, einer primären Kommunikationsstrecke zwischen dem jeweiligen Sensor und dem Datensammler, einem Head-End zur Auswertung der Daten sowie einer tertiären Kommunikationsstrecke zwischen Datensammler und Head-End. Gemäß der vorliegenden Erfindung ist das Messdaten-Informationsnetzwerk dadurch gekennzeichnet, dass als Sensor ein Sensor nach Anspruch 22 vorgesehen ist.

### Beschreibung der Erfindung anhand von Ausführungsbeispielen

Nachstehend wird die vorliegende Erfindung anhand verschiedener Ausführungsbeispiele näher erläutert. Es zeigen:
- Fig. 1: eine stark vereinfachte schematische Darstellung eines Beispiels von Kommunikationsstrecken eines Versorgungsnetzes zum Sammeln und/oder Weiterleiten von Daten, die von einer Vielzahl von Verbrauchszählern aufgenommen werden, an einen Datensammler und ein Head-End;
- Fig. 2a-b: stark vereinfachte schematische Darstellungsweisen eines Beispiels der Übertragung von Zeitstempelungen charakteristischer Rohmessdaten und Verbrauchsdaten über verschiedene Kommunikationsstrecke zum Head-End;
- Fig. 3: ein Beispiel für eine Nachrichtenstruktur, die von der Messdatenaufbereitung des Verbrauchszählers über die primäre Kommunikationsstrecke emittiert bzw. abgefragt wird;
- Fig. 4: ein Beispiel für ein Chronogramm von Zeitstempelungen von den von einem Sensor ausgelesenen Rohmessdaten zwischen zwei Uplink-Übertragungsvorgängen (Nachrichten oder Telegramme, die zu den Zeitpunkten T_{E-1} und T_{E} emittiert werden), in einem Kontext der Fernablesung des Volumenverbrauchs (in diesem Fall enthält das Paket PAⱼ N Zeitstempelungen);
- Fig. 5: ein Beispiel für das Zusammenfügen der die Zeitstempelungen enthaltenen Datenpakete bzw. Nachrichten bzw. Telegramme sowie Rekonstruktionen zu einem zeitkontinuierlichen Rohmessdatenstrom einschließlich dessen Auswertemöglichkeiten in stark vereinfachter schematischer Darstellungsweise;
- Fig. 6: ein Beispiel eines Sensors eines Verbrauchszählers in Form eines mechanischen Durchflusszählers mit einem Flügelrad, mit dem entsprechende Zeitstempelungen von Rohmessdaten für den Durchfluss erzeugt werden können;
- Fig. 7: ein Beispiel eines auf Korrelationsmodells zur Generierung von Zeitstempelungen auf Basis der von dem Sensor gemäß Fig. 6 erfassten Rohmessdaten;
- Fig. 8: ein Beispiel eines Temperatursensors in vereinfachter Darstellung;
- Fig. 9: ein weiteres Beispiel eines Korrelationsmodells zur Generierung von Zeitstempelungen auf Basis der von dem Sensor gemäß Fig. 8 erfassten Rohmessdaten;
- Fig. 10: eine stark vereinfachte Darstellungsweise der Bereithaltung der nicht-dekomprimierten Zeitstempelungen im Head-End;
- Fig. 11: eine stark vereinfachte Darstellungsweise der Kompensation von Zeitstempelungen durch Verbrauchsdaten im Head-End; sowie
- Fig. 12: eine stark vereinfachte Darstellungsweise einer Konsistenzkontrolle der Daten durch Vergleich der Zeitstempelungen mit den Verbrauchsdaten im Head-End.

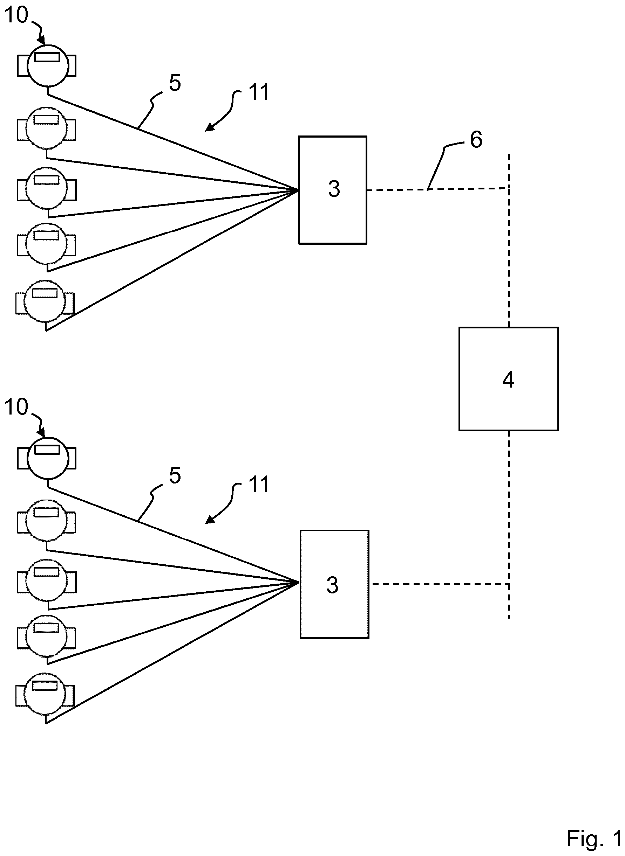

Fig. 1 zeigt ein Messdaten-Informationsnetzwerk, z.B. im Rahmen der Verteilung von Verbrauchsgütern, wie z.B. Gas, Wasser, Elektrizität, Treibstoff oder Wärme. Das Versorgungsnetz umfasst eine Vielzahl von einzelnen lokalen angeordneten Verbrauchszählern 10, die z.B. unterschiedlichen Wohneinheiten eines Mehrfamilienhauses zugeordnet sein können. Die einzelnen Verbrauchszähler 10, z.B. Wasserzähler, Durchflusszähler, Wärmezähler, Elektrizitätszähler oder Gaszähler, sind über eine primäre Kommunikationsstrecke 5 per Funk (Funkstrecke 11) mit einem (ortsfesten oder mobilen) Datensammler 3, der als Master bzw. Konzentrator fungieren kann, verbunden.

Jeder einzelne Verbrauchszähler 10 kann zweckmäßigerweise mit einer zugehörigen ID (Adresse) versehen sein, sodass jeder einzelne Verbrauchszähler 10 vom Datensammler 3 direkt adressiert werden kann und die im jeweiligen Verbrauchszähler 10 vorhandenen Daten abgerufen werden können.

Die Übertragung über die primäre Kommunikationsstrecke 5 wird durch ein BUS-Übertragungsprotokoll vorgegeben, wie z.B. durch das wireless M-BUS-Übertragungsprotokoll.

Der jeweilige Datensammler 3 steht über eine tertiäre Kommunikationsstrecke 6 mit einem sogenannten Head-End 4 in Verbindung. Im Head-End 4 laufen die Daten des gesamten Versorgungsnetzes zusammen. Bei der tertiären Kommunikationsstrecke 6 kann es sich um eine drahtgebundene Kommunikationsstrecke oder um eine auf Funktechnologie basierende Kommunikationsstrecke (z.B. Mobilfunk-Kommunikationsstrecke) handeln. Alternativ können die Daten des jeweiligen Datensammlers 3 bei Bedarf auch von einer portablen Leseeinrichtung ausgelesen und am Head-End 4 wieder eingelesen werden. Die Daten können entlang der tertiären Kommunikationsstrecke 6 auf unterschiedliche Art und Weise übertragen werden, beispielsweise via LAN, GPRS, LTE, 3G usw.

Die einzelnen Verbrauchszähler 10 können mit einer eigenständigen Energieversorgung (Akku) betrieben werden.

Wie in Fig. 1 schematisch dargestellt, werden die vorzugsweise komprimierten und formatierten Zeitstempelungen TS jedes betreffenden Sensors 1 bzw. Verbrauchszählers 10 an den Datensammler 3, der ein lokales Netzwerk einer Vielzahl von ihm zugeordneten Verbrauchszählern 10 bzw. Sensoren 1 verwaltet, übertragen. Von dem Datensammler 3 werden die vorzugsweise komprimierten und formatierten Zeitstempelungen TS jedes der Sensoren 1, die Teil des Versorgungsnetzes sind, an das Head-End 4 übertragen.

Der Datensammler 3 kann die von den jeweiligen Sensoren 1 bzw. Verbrauchszählern 10 abgerufenen Zeitstempelungen TS entweder über ein Zeitintervall (z.B. einen Tag) speichern und dann an einen Verarbeitungsstandort bzw. an das Head-End 4 weiterleiten. Alternativ können die Daten vom Datensammler 3 auch sofort an das Head-End 4 weitergeleitet werden.

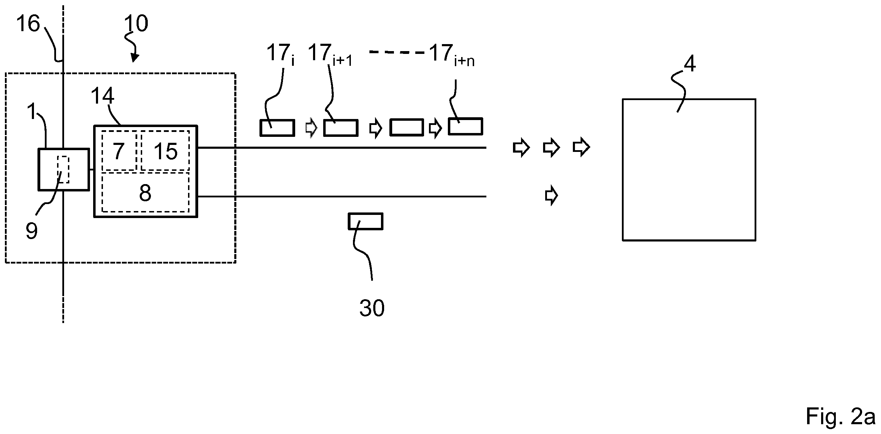

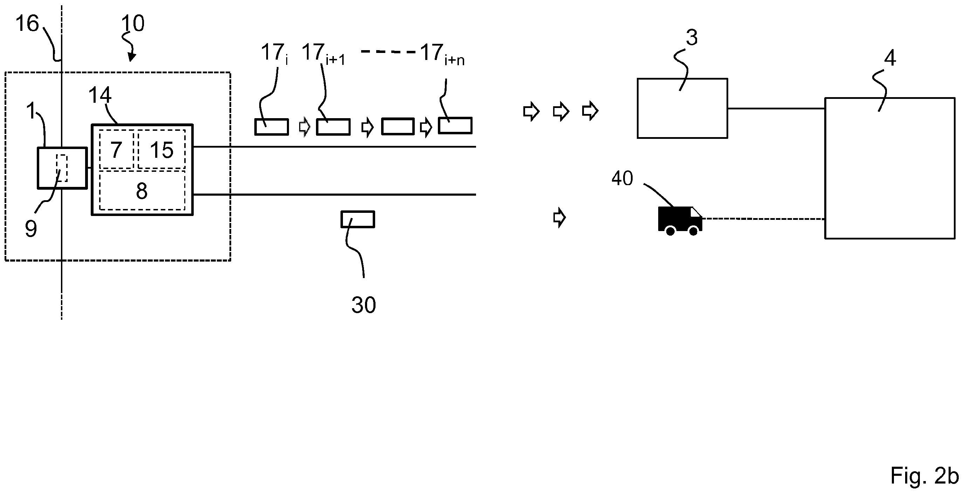

Gemäß Fig. 2a und 2b umfasst der jeweilige Verbrauchszähler 10 einen mit mindestens einem Messelement 9 ausgestatteten Sensor 1. Der Sensor 1 ist dazu vorgesehen, über das Messelement 9 Rohmessdaten zu erzeugen, die einer Messdatenaufbereitung 14 zugeführt werden. Die Rohmessdaten entsprechen vom Messelement 9 gelieferten elementaren Messeinheiten der mindestens einen physikalischen oder physikalisch-chemischen Größe oder des mindestens einen physikalischen oder physikalisch-chemischen Parameters. Bei den Rohmessdaten kann es sich beispielsweise um Rohdaten in Zusammenhang mit dem Durchfluss eines Mediums durch eine Versorgungsleitung 16, z.B. Wasserleitung, handeln, insbesondere die Durchflussmenge, die Trübung, das Vorhandensein von Schadstoffen oder das Vorhandensein eines festen und/oder gasförmigen Anteils bzw. fester und/oder gasförmiger Anteile. Es sei darauf hingewiesen, dass es sich bei dem Sensor 1 um alternativ auch um einen Drucksensor, Temperatursensor, Feuchtesensor, Beschleunigungssensor, Höhensensor oder Bewegungssensor handeln kann.

Die Messwertaufbereitung 14 des Verbrauchszählers 10 umfasst Speichermittel 7, eine Zeitreferenzeinrichtung 15 (Quarz) sowie einen Mikroprozessor 8. Die vorgenannten Komponenten können getrennt oder als integrierte Gesamtkomponente vorgesehen sein. Der Verbrauchszähler 10 kann eine (nicht dargestellte) eigene Stromversorgung in Form einer Batterie oder dergleichen bei Bedarf umfassen. Somit kann der Verbrauchszähler 10 energieautark betrieben werden.

Im Vorfeld zu den in Fig. 2a und Fig. 2b dargestellten Schritten werden im Rahmen des Korrelierungsmodells ein bestimmter Wert, eine bestimmte Wertänderung oder eine bestimmte Wertdifferenz der mindestens einen physikalischen oder physikalisch-chemischen Größe oder des mindestens einen physikalischen oder physikalisch-chemischen Parameters für die Zuordnung einer Zeitstempelung TS festgelegt.

Wie in Fig. 2a dargestellt, erfolgen im Bereich des jeweiligen Verbrauchszählers 10 erfindungsgemäß folgende Schritte:
- Auslösen einer Zeitstempelung TS bei einem Erfassen des bestimmten Werts, der bestimmten Wertänderung oder der bestimmten Wertdifferenz durch das Messelement 9.
- Abspeichern der Zeitstempelungen TS in den Speichermitteln 7 des Sensors 1 bzw. des Verbrauchszählers 10.
- Erzeugung von Verbrauchsdaten aus den elementaren Messeinheiten. Die Verbrauchsdaten werden hierbei bis zur Übertragung in den Speichermitteln 7 abgespeichert.
- Übertragen der Zeitstempelungen TS, vorzugsweise in komprimierter Form über eine Funkstrecke 11, indem in der Messdatenaufbereitung 14 Zeitstempelung-Telegramme 17ᵢ, 17ᵢ₊₁, 17ᵢ₊ₙ vorbereitet werden, die sukzessive an eine zentrale Verarbeitungsanlage, wie z.B. ein Head-End 4, übertragen werden. Die Kompression (Komprimierung) für die Übertragung nimmt der Mikroprozessor 8 vor.
- Übertragen der Verbrauchsdaten in nicht-komprimierter Form über eine Funkstrecke 11, indem in der Messdatenaufbereitung 14 ein Verbrauchsdaten-Telegramm 30 vorbereitet wird, welches an eine zentrale Verarbeitungsanlage, wie z.B. ein Head-End 4, übertragen wird.

Dementsprechend werden zeitlich nacheinander Zeitstempelung-Telegramme 17ᵢ, 17ᵢ₊₁, ...., 17ᵢ₊ₙ übertragen, die fortlaufende Zeitstempelungen TS enthalten. Aus diesen Zeitstempelungen TS kann empfängerseitig unter Anwendung des Korrelierungsmodells ein kontinuierlicher lückenloser Rohmessdatenstrom von sehr hoher Auflösung rekonstruiert werden.

Die vorzugsweise komprimierten Zeitstempelungen TS und die vorzugweise nicht-komprimierten Verbrauchsdaten werden parallel vom Verbrauchszähler 10 übertragen. Diese beiden Arten von Daten können kombiniert werden, beispielsweise im Head-End 4. Durch die Kombination der Daten können weitere Informationen über den Verbrauchszähler bzw. über das Messdaten-Informationsnetzwerk generiert werden.

In Fig. 2b ist eine alternative Übertragung der Zeitstempelungen TS und der Verbrauchsdaten gezeigt. Die nicht-komprimierten Verbrauchsdaten werden über einen mobilen Datensammler 40, beispielsweise während einem Drive-by, Walk-By oder ähnlichem, ausgelesen. Der mobile Datensammler 40 kann während einer Auslese-Tour eine Mehrzahl an Verbrauchszählern 10 auslesen. Nach der Auslese-Tour überträgt der mobile Datensammler 40 die aufgenommenen Verbrauchsdaten an das Head-End 4. Die vorzugsweise komprimierten Zeitstempelungen TS werden beispielsweise über ein Messdaten-Informationsnetzwerk übertragen, welches eine primäre Kommunikationsstrecke 5 in Form einer Funkstrecke 11 zu einem Datensammler 3 aufweist. Der Datensammler 3 ist wiederum über eine tertiäre Kommunikationsstrecke 6 mit dem Head-End 4 verbunden. Die Daten können entlang der tertiären Kommunikationsstrecke 6 auf unterschiedliche Art und Weise übertragen werden, beispielsweise via LAN, GPRS, LTE, 3G usw.

Im Head-End 4 werden die Zeitstempelungen TS und die Verbrauchsdaten kombiniert, um weitere Informationen zu erzeugen.

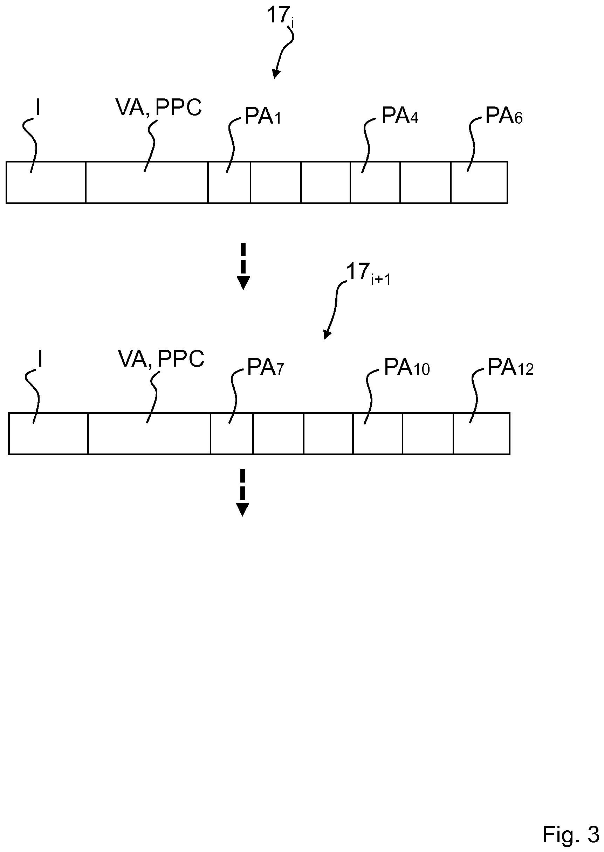

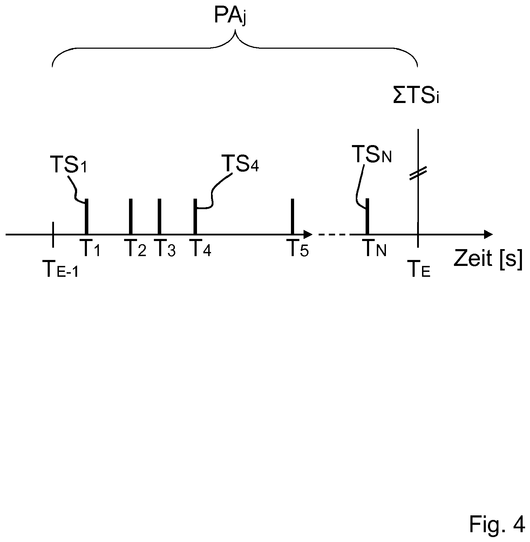

Wie in Figur 3 beispielhaft dargestellt, kann zudem vorgesehen sein, zusammen mit den PAⱼ-Paketen der Zeitstempelungen TS auch die Identität (Adresse) I des betreffenden Sensors 1 und/oder den absoluten oder kumulierten Wert VA der bzw. des vom betreffenden Sensor 1 gemessenen physikalischen oder physikalisch-chemischen Größe oder Parameters in dem jeweiligen Zeitstempelung-Telegramm 17ᵢ, 17ᵢ₊₁, ...., 17ᵢ₊ₙ zu übertragen, wobei der Wert VA mit einem Zeitstempel versehen oder einem der elementaren zeitgestempelten Messdaten, beispielsweise einem Indexwert eines Fluidzählers zugeordnet sein kann. Der Wert VA kann - gemäß Ausführungsbeispiel - z.B. der Zählerstand eines Wasserzählers zu einem bestimmten Zeitpunkt oder die Durchflussmenge durch den Wasserzähler seit einer vorherigen Datenübertragung (z.B. entspricht die Summe Σ der Zeitstempelungen TSᵢ der Summe Σ der Durchflussmenge; siehe Figur 4) sein.

Das Verfahren kann auch darin bestehen, mit den PAⱼ-Paketen von Zeitstempelungen TS den Wert mindestens eines anderen physikalischen oder physikalisch-chemischen Parameters PPC der Umgebung des betreffenden Sensors 1 oder des von diesem letzteren gemessenen Fluids zu einem bestimmten Zeitpunkt auszulesen und zu übertragen, wie beispielsweise die Leitfähigkeit des Fluids, die Temperatur des Fluids, den pH-Wert des Fluids, den Druck des Fluids, und/oder einen Parameter, der für die Qualität und/oder die Zusammensetzung des Fluids und/oder die Temperatur der Einbauumgebung des Sensors 1 kennzeichnend ist.

Fig. 3 zeigt beispielhaft die einzelnen Zeitstempelung-Telegramme 17ᵢ, 17ᵢ₊₁, ...., 17ᵢ₊ₙ gemäß Fig. 2a bzw. Fig. 2b etwas detaillierter. Die Zeitstempelung-Telegramme 17ᵢ, 17ᵢ₊₁, ...., 17ᵢ₊ₙ umfassen jeweils zum einen eine Mehrzahl von Datenpaketen PA₁-PA₆ bzw. PA₇-PA₁₂, den absoluten oder kumulierten Wert VA sowie den Wert mindestens eines anderen physikalischen oder physikalisch-chemischen Parameters PPC der Umgebung des betreffenden Sensors 1 oder des von letzterem zu einem bestimmten Zeitpunkt gemessenen Fluids, wie z.B. die Leitfähigkeit des Fluids, die Temperatur des Fluids, den pH-Wert des Fluids, den Druck des Fluids, einen Parameter, der für die Qualität und/oder die Zusammensetzung des Fluids und/oder die Temperatur der Einbauumgebung des Sensors 1 kennzeichnend ist.

Wie in Fig. 3 weiterhin als Beispiel dargestellt ist, kann vorgesehen sein, die komprimierten Zeitstempelungen TS durch Formatierung der PAⱼ-Pakete, deren Größe einen vorgegebenen Maximalwert nicht überschreiten darf, zu verpacken, wobei jedes Mal, wenn die akkumulierten Daten die Größe eines Pakets PAⱼ erreichen, ein neues Paket bzw. Telegramm gebildet wird bzw. eine neue Übertragung ausgelöst wird, sofern das vorgegebene Zeitintervall nicht vorher abgelaufen ist.

Gemäß einer bevorzugten Variante der Erfindung werden die Zeitstempelungen TS vor deren Übertragung komprimiert. Die Komprimierung der Zeitstempelungen TS kann verlustfrei durchgeführt werden.

Alternativ kann die Komprimierung der Zeitstempelungen TS auch mit einem vorgegebenen zulässigen Verlustniveau durchgeführt werden. In der Tat kann, wenn der Benutzer oder Betreiber eine Energieeinsparung bevorzugt und eine gewisse Ungenauigkeit bei der Wiederherstellung und Wiedergabe der ursprünglichen Rohmessdaten akzeptiert (d. h. einen gewissen Verlust akzeptiert), das Komprimierungsverhältnis dann zum Nachteil einer geringeren zeitlichen Genauigkeit bei der Wiedergabe auf der Empfangsseite erhöht werden. Dieses Verlustverhältnis oder das Komprimierungsverhältnis kann als programmierbarer oder einstellbarer Parameter vorgesehen werden, der den Komprimierungsmodus bestimmt oder einstellt.

Als anschauliche und nicht beschränkende Beispiele für Datenkomprimierungsalgorithmen kann im Rahmen des erfindungsgemäßen Verfahrens in Betracht gezogen werden, eine differentielle Kodierung (Delta-Kodierung) in Verbindung mit einer Huffman-Kodierung, eine Lauflängenkodierung (RLE-Kodierung) oder vorzugsweise eine adaptive binäre arithmetische Kodierung (CABAC-Kodierung) anzuwenden.

Es besteht die Möglichkeit, dass die Zeitstempelungen TS in den Speichermitteln 7 des Verbrauchszählers 10 erst dann gelöscht werden, wenn die Übertragung der Zeitstempelungen TS vom Empfänger bzw. Datensammler 3 bestätigt worden ist.

Dank der Erfindung ist es möglich, am Datensammler 3 bzw. Empfangsort (z. B. Head-End 4) über Informationen zu verfügen, die eine originalgetreue und vollständige Rekonstruktion aller von den verschiedenen Sensoren 1 gelieferten Zeitstempelungen TS in sehr hoher zeitlicher Auflösung ermöglichen und eine unbegrenzte Flexibilität bei der Auswertung dieser Daten zulassen. So kann man einfach und zentral die Erweiterungsfähigkeit von "Business"-Funktionen berücksichtigen, ohne die Funktionsweise oder gar den Aufbau von Baugruppen (Sensoren, Kommunikationsmittel, und dergleichen) zu beeinflussen.

Der Aufbau des Sensors 1 kann im Vergleich zu bisher bekannten Lösungen einfacher und sein Betrieb sicherer sein. Ferner ist der Energieverbrauch der Baugruppe aus dem Sensor 1 und den Kommunikationsmitteln 2 geringer als bei den aktuellen Ausführungen, welche die Daten lokal auswerten.

Die Erfindung kann auf die Messung und Fernauslesung verschiedenster Parameter und Größen angewendet werden. Es genügt, eine elementare (vom Sensor 1 messbare) Veränderung eines Parameters oder einer Größe in Übereinstimmung mit der Auflösung des betrachteten Sensors 1 genau datieren zu können (die Zeitstempelung TS kann der Auflösung des Sensors 1 oder möglicherweise einem Vielfachen dieser Auflösung entsprechen).

Wenn sich die gemessene Größe oder der gemessene Parameter auch dekrementell ändern kann, sind die Zeitstempelungen TS mit Vorzeichen versehene elementare Maßeinheiten (positive oder negative Einheiten).

Im Zusammenhang mit einer vorteilhaften Anwendung der Erfindung, verbunden mit dem Begriff des Verbrauchs, kann vorgesehen sein, dass die oder eine der gemessenen physikalischen Größe(n) sich auf ein Strömungsmedium bezieht, wobei jede Zeitstempelung TS einer elementaren Fluidmenge entspricht, die durch den Sensor 1, abhängig von seiner Messgenauigkeit, gemessen wird. Das gemessene Fluid kann beispielsweise Gas, Wasser, Kraftstoff oder eine chemische Substanz sein.

Alternativ oder kumulativ zu der oben genannten Ausführungsvariante kann die Erfindung auch vorsehen, dass die oder eine der gemessene(n) physikalischchemische(n) Größe(n) ausgewählt ist aus der Gruppe, die gebildet wird durch die Temperatur, den pH-Wert, die Leitfähigkeit und den Druck eines durch den betreffenden Sensor 1 hindurchströmenden oder von diesem kontaktierten Fluids.

Wenn alternativ oder kumulativ mindestens ein Parameter gemessen wird, kann dieser oder einer dieser gemessene(n) physikalische(n) oder physikalisch-chemische(n) Parameter kennzeichnend sein für die Qualität und/oder Zusammensetzung eines Fluids, das den betreffenden Sensor 1 durchströmt oder mit ihm in Kontakt kommt, wie z. B. Trübung, das Vorhandensein von Schadstoffen oder das Vorhandensein eines festen und/oder gasförmigen Anteils bzw. fester und/oder gasförmiger Anteile.

Die oben genannten Größen und Parameter sind selbstverständlich nur Beispiele, die nicht beschränkend sind.

Dementsprechend werden fortlaufend Zeitstempelung-Telegramme 17 zu einem bestimmten Zeitpunkt gebildet und sukzessive übertragen. Die einzelnen Datenpakete PA₁, ..., PAₙ bilden im Anschluss daran in ihrer Summe einen fortlaufenden zeitgestempelten Rohmessdatenstrom 13.

Fig. 4 zeigt exemplarisch ein Beispiel für eine Nachrichtenstruktur, die vom Sensor 1 bzw. z.B. dem Verbrauchszähler 10 an den Datensammler 3 bzw. an das Head-End 4 übertragen wird. Jede Zeitstempelung TS, bis TS_{N} entspricht hierbei im Rahmen des Korrelierungsmodells einer elementaren Fluidmenge, die durch den Sensor 1 gemessen wird. Das gemessene Fluid kann beispielsweise Gas, Wasser, Kraftstoff oder eine chemische Substanz sein. In dem Zeitintervall T_{E-1} bis T_{E} werden so N Impulse gemessen und die Zeitstempelungen TS₁ bis TS_{N} gespeichert, was bei einer Menge von z. B. einem Liter pro Zeitstempelung TS einer Durchflussmenge von insgesamt N Liter innerhalb dieses Zeitintervalls entspricht. Die Messwertaufbereitung bildet ein Datenpaket PAⱼ, welches N Zeitstempelungen TS₁ bis TS_{N} enthält. Aus der Mehrzahl von Datenpaketen z. B. PA, bis PA₆ bzw. PA₇ bis PA₁₂ werden gemäß Fig. 3 Datentelegramme 17ᵢ, 17ᵢ₊₁ gebildet.

Damit sich das erfindungsgemäße Verfahren an Veränderungen in der Entwicklung des Parameters oder der Messgröße anpassen kann und gleichzeitig eine zufriedenstellende Aktualisierung der verfügbaren Momentandaten gewährleistet ist, kann das Verfahren vorteilhafterweise insbesondere darin bestehen, ein neues Paket bzw. Telegramm 17 zu bilden bzw. eine neue Datenübertragung in Form einer Nachricht oder eines Telegramms durchzuführen, sobald mindestens die nachfolgende Bedingung b) erfüllt ist:
(a) Ein vorgegebenes Zeitintervall ist abgelaufen und/oder
(b) eine vorgegebene Menge an insbesondere komprimierten gesammelten Daten bzw. Zeitstempelungen TS seit der vorherigen Übertragung ist erreicht.

Die Anwendung der genannten Bedingung (b) kann beispielsweise darin bestehen, nachdem eine vorgegebene Anzahl neuer Zeitstempelungen TS erstellt wurde, regelmäßig die Größe aller neuen Zeitstempelungen TS in komprimierter oder verdichteter Form zu überprüfen. Wenn diese Größen nahe einer kritischen Größe liegen, beispielsweise nahe der Größe eines durch das Übertragungsprotokoll festgelegten Pakets, wird ein neuer Übertragungsvorgang durchgeführt (Bedingung (b) vor Bedingung (a) erfüllt), es sei denn, das vorgegebene Zeitintervall zwischen zwei aufeinanderfolgenden Übertragungen ist zuerst abgelaufen (Bedingung (a) vor Bedingung (b) erfüllt).

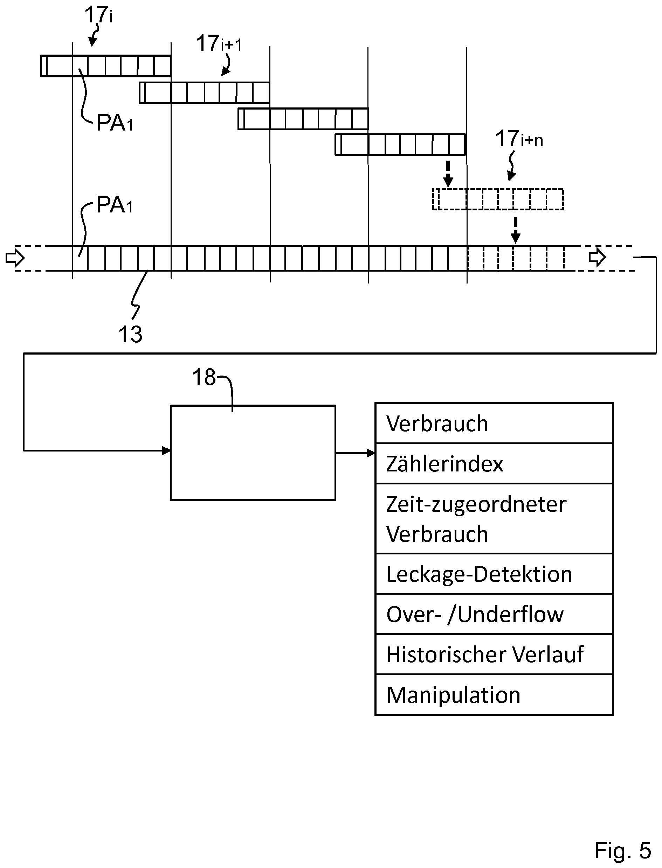

Fig. 5 zeigt die Weiterverarbeitung der einzelnen in Zeitstempelung-Telegrammen 17ᵢ- 17ᵢ₊ₙ bereitgestellten Zeitstempelungen TS zu einer fortlaufenden zusammenhängenden Zuordnung, aus der anhand des Korrelierungsmodells ein lückenloser Rohmessdatenstrom 13 rekonstruiert werden kann. Hierbei werden die einzelnen Zeitstempelung-Telegramme 17ᵢ - 17ᵢ₊ₙ so zusammengefügt, dass die jeweiligen Daten bzw. Datenpakete PAⱼ bzw. die darin enthaltenen Zeitstempelungen TS in Zeitrelation mit den benachbarten Datenpaketen PAⱼ gebracht werden.

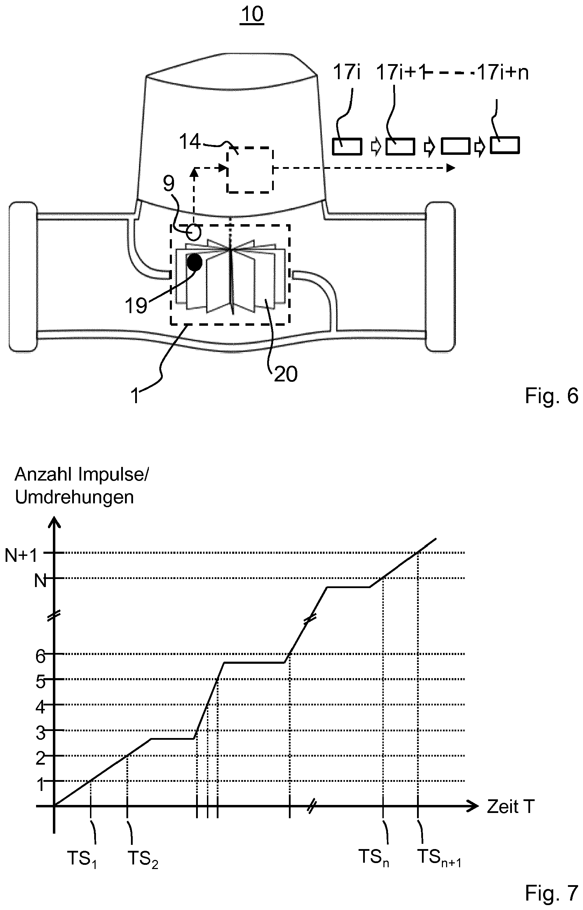

In Fig. 6 ist lediglich beispielhaft ein mechanischer Durchflusszähler 10 mit einem Sensor 1 für den Durchfluss dargestellt. Der Sensor 1 umfasst ein Flügelrad 20, ein Messelements 9 in Form z.B. eines Hallsensors sowie ein Impulsgeberelement 19, welches sich abhängig von dem Durchfluss durch den Durchflusszähler 10 hindurch mehr oder weniger dreht. Die Drehbewegung des Flügelrads 20 wird von dem Messelement 9 als Spannungswert erfasst, der von dem Impulsgeberelement 19 angeregt wird, sofern sich der betreffende Flügel des Flügelrads 20 in der Position des Messelements 9 befindet. Durch das Korrelierungsmodell ist beim Auswerten bekannt, welchem Durchflussvolumen eine Umdrehung entspricht. So kann eine Umdrehung des Flügelrades 20 z.B. einem Liter an Fluid entsprechen.

In der Messwertaufbereitung 14 ist ein Korrelierungsmodell hinterlegt, mit dem die Bedingungen für das Generieren von Zeitstempelungen TS bei bestimmten Rohmesswerten vorher festgelegt sind. Fig. 7 zeigt ein vereinfacht dargestelltes Beispiel eines solchen Korrelierungsmodells z. B. für eine fortlaufende kumulierende Durchflussmessung. Die Messeinheit ist hierbei z. B. ein vom Messelement 9 des in Fig. 6 dargestellten Sensors 1 erfasster Impuls z. B. ein Spannungsimpuls, der einer Umdrehung des Flügelrades 20 entspricht. Die vordefinierte Auflösung des Messverfahrens entspricht daher in diesem Beispiel einer Umdrehung des Flügelrads 20. Die Rohmesswerte, also die durch die Umdrehungen ausgelösten Impulse sowie die zugehörige Zeiten T, werden in den Speichermitteln 7 des Sensors 1 abgespeichert. Die Messwertaufbereitung 14 generiert für jeden Rohmesswert (d. h. für jede Umdrehung/Impuls) eine zugehörige Zeitstempelung TS₁, TS₂...... bis TSₙ₊₁. Die Zeitstempelungen TS werden fortlaufend in den Speichermitteln 7 abgelegt. Dreht sich das Flügelrad 20 nicht, wird kein Impuls erzeugt und somit auch keine Zeitstempelung vorgenommen. Dreht sich das Flügelrad 20 langsamer, erfolgt der Zeitpunkt der Erfassung des Impulses entlang der Zeitachse T entsprechend später. Dementsprechend wird in diesem Fall eine spätere Zeitstempelung TS erzeugt. Wie aus Fig. 7 ersichtlich, werden somit eine Vielzahl von Zeitstempelungen TS generiert, die den über die betreffende Zeitspanne kontinuierlich gemessenen Durchfluss definieren.

Die Zeitstempelungen TS werden in Datenpaketen PAⱼ zusammengefasst und gemäß Fig. 2 als Datentelegramme 17ᵢ, 17ᵢ₊₁, 17ᵢ₊ₙ sukzessive nach Aufforderung durch den Datensammler 3 über die primäre Kommunikationsstrecke 5 an diesen übertragen. Die Datenübertragung kann hierbei vorzugsweise in komprimierter Form erfolgen. Es handelt es sich folglich um einen kontinuierlichen lückenlosen Zeitstempelungs-Datenstrom von sehr hoher Auflösung, der in Form der einzelnen fortlaufenden Datentelegramme 17ᵢ, 17ᵢ₊₁, ...., 17ᵢ₊ₙ entlang der primären Kommunikationsstrecke 5 übertragen wird.

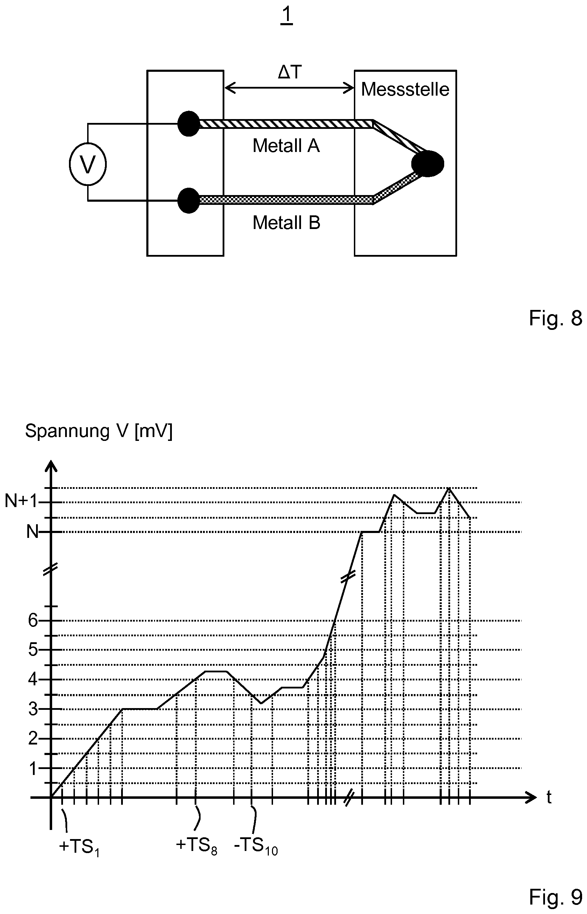

Die Sammlung von Daten ist nicht auf eine Durchflussmessung beschränkt. Fig. 8 zeigt beispielsweise einen Sensor 1 in Form eines auf Widerstandsmessung basierenden Temperaturfühlers. Der Temperaturfühler umfasst zwei im Bereich einer Messstelle miteinander verbundener Metallleiter (A, B) mit unterschiedlicher Wärmeleitfähigkeit. Im Falle eines Temperaturunterschieds ΔT zwischen der Messstelle und dem gegenüberliegenden Ende der beiden Leiter kann eine Spannung V bzw. Spannungsänderung abgegriffen werden. In diesem Fall kann als Korrelierungsmodell eine Zeitstempelung TS für eine Änderung der vom Sensor erfassten Spannung festgelegt werden.

Fig. 9 zeigt ein Beispiel für eine entsprechende Rohmessdatenkurve von Spannungswerten V zur Generierung von entsprechenden Zeitstempelungen TS bei einer Temperaturmessung. Dementsprechend wird bei jedem Anstieg oder Abfall der Spannung z. B. um 0,5 mV eine zugehörige Zeitstempelung TS generiert. Die festgelegte Auflösung des Verfahrens beträgt somit 0,5 mV. Da der Kurvenverlauf bei einer Temperaturmessung aufsteigend sowie abfallend sein kann, werden in diesem Fall die Zeitstempelungen mit einem Vorzeichen "+" für ansteigend oder "-" für abfallend versehen. Wie aus Fig. 9 deutlich wird, erhält man auch hier eine kontinuierliche Abfolge von Zeitstempelungen TS, die den gemessenen Spannungsverlauf und somit die Temperatur über den betrachteten Zeitraum sehr genau und lückenlos abbilden. Ändert sich die Temperatur d. h. die Spannung V nicht, wird keine Zeitstempelung generiert. Im Übrigen entspricht das Verfahren den in Zusammenhang mit dem eingangs beschriebenen Beispiel der Durchflussmessung dargelegten Maßnahmen.

Durch die erfindungsgemäße Sammlung von Zeitstempelungen TS, die von den Sensoren 1 bzw. Verbrauchszählern 10 des oder eines bestimmten Netzwerks geliefert werden, ermöglicht die Erfindung alle Arten von Auswertung, Analyse, Überprüfung, Überwachung sowie allgemein nützlicher oder gewünschter Verarbeitung und Verwertung, da die grundlegende einzelne Rohinformation zur Verfügung steht. Die Auswertung der bereitgestellten Zeitstempelungen TS erfolgt vorzugsweise im Bereich des Head-Ends 4 über Auswertemittel 18 und ergibt eine Vielzahl wichtiger Informationen, die für die Verwaltung des Versorgungsnetzes notwendig sind, bisher aber noch nicht generiert werden konnten, wie z.B. Verbrauch, Zählerindex, zeitzugeordneter Verbrauch, Leckage-Detektion, Over-/Underflow, historischer Verlauf und/oder Manipulation. Informationen können somit jederzeit auch retrospektive zeitlückenlos abgerufen und einer bisherigen Auswertung zugeführt werden.

Die aus den Zeitstempelungen TS rekonstruierten Rohmessdaten liegen im Head-End 4 erfindungsgemäß als Rohmessdatenstrom 13 in sehr hoher Auflösung bzw. Granularität ohne zeitliche Lücken vor. Demzufolge liegen im Gegensatz zu bisherigen Verfahren aufgrund des erfindungsgemäßen Verfahrens im Head-End 4 sehr viel mehr verwertbare Daten vor als bisher.

Der im Head-End 4 vorliegende Rohmessdatenstrom 13 besitzt vorzugsweise eine Auflösung im Sekundenbereich, Zehntelsekundenbereich, Hundertstelsekundenbereich, Tausendstelsekundenbereich oder sogar Zehntausendstelsekundenbereich.

Gegenstand der Erfindung ist auch, wie in Fig. 1 schematisch dargestellt, ein Messdaten-Informationsnetzwerk beispielsweise für ein Versorgungsnetz zur Verteilung eines insbesondere fluiden Verbrauchsguts, z.B. unter Einsatz entsprechend hergerichteter Verbrauchszähler 10, die Sensoren 1 beinhalten, die in dem Versorgungsnetz betrieben werden. Der jeweilige Verbrauchszähler 10 umfasst, vgl. Fig. 2, mindestens einen Sensor 1, welcher über ein Messelement 9 Rohmessdaten erfassen kann. Des Weiteren umfasst der jeweilige Verbrauchszähler 10 eine Messdatenaufbereitung 14, die einen Mikroprozessor 8, Speichermittel 7 sowie eine Zeitreferenzeinrichtung 15 beinhaltet. In der Messdatenaufbereitung 14 erfolgt eine Zeitstempelung TS aufgrund der Rohmessdaten, eine Komprimierung der Zeitstempelungen TS sowie eine Aufbereitung in ein Format, das zur Übertragung über eine Funkstrecke 11 bzw. über die primäre Kommunikationsstrecke 5 gemäß einem bestimmten Protokoll geeignet ist.

Der Verbrauchszähler 10 kann eine (nicht dargestellte) eigene Stromversorgung in Form einer Batterie oder dergleichen bei Bedarf umfassen. Somit kann der Verbrauchszähler 10 energieautark betrieben werden.

Im Bereich des Head-Ends 4 sind gemäß Fig. 5 Auswertemittel 18 vorgesehen, die in der Lage sind, die Zeitstempelungen TS in den einzelnen Zeitstempelung-Telegrammen 17ᵢ - 17ᵢ₊ₙ bzw. deren Datenpakete PAⱼ zeitkontinuierlich und ohne Lücken zu einem fortlaufenden lückenlosen Rohmessdatenstrom 13 zusammenzuführen und hieraus entsprechende Dekomprimierungen, Auswertungen, Berechnungen und dergleichen vorzunehmen. Die entsprechenden Daten umfassen vorzugsweise alle in dem Messdaten-Informationsnetzwerks bzw. Versorgungsnetz befindlichen Sensoren 1 bzw. Verbrauchszähler 10.

Darüber hinaus umfasst das vorgenannte System für das betreffende oder jedes geografische Gebiet, in dem die Verbrauchszähler 10 installiert sind, einen festen Datensammler 3 (Konzentrator), der mit den Verbrauchszählern 10 des Gebietes, das ihm zugewiesen ist, eine primäre Kommunikationsstrecke 5 des Versorgungsnetzes bildet. Die primäre Kommunikationsstrecke 5 kann beispielsweise als Funkstrecke 11 ausgebildet sein. Der Datensammler 3 ist wiederum über eine tertiäre Kommunikationsstrecke 6 mit dem Head-End 4 verbunden. Die Daten können entlang der tertiären Kommunikationsstrecke 6 auf unterschiedliche Art und Weise übertragen werden, beispielsweise via LAN, GPRS, LTE, 3G, 4G usw.

Vorzugsweise bilden die Speichermittel 7 eines jeden Sensors 1 bzw. Verbrauchszählers 10 einen Pufferspeicher und sind geeignet und dazu hergerichtet, den Inhalt mehrerer PAⱼ-Pakete von Zeitstempelungen TS insbesondere im komprimierten Zustand zu speichern, wobei der Inhalt oder ein Teil des Inhalts dieses Pufferspeichers bei jeder Übertragung bzw. Abruf durch den Datensammler 3 übertragen wird.

Die von jedem Datensammler 3 gesammelten Informationen werden direkt oder indirekt an das Head-End 4 übermittelt. Dort werden auch die "Business"-Funktionen definiert und ausgeführt.

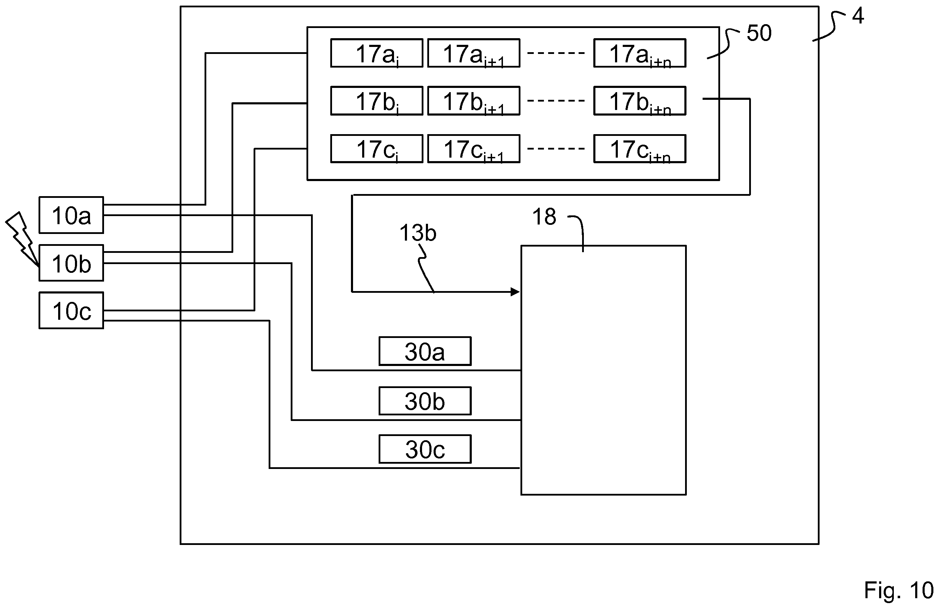

In einer Ausgestaltung gemäß Fig. 10 ist es vorgesehen, dass detaillierte Informationen auf Basis der Zeitstempelungen TS bei Bedarf (on-demand) zur Verfügung gestellt werden. Fig. 10 zeigt beispielhaft drei Verbrauchszähler 10a, 10b und 10c, welche jeweils Zeitstempelung-Telegramme 17a, 17b und 17c sowie Verbrauchsdaten-Telegramme 30a, 30b und 30c an das Head End 4 übertragen. Die Zeitstempelungen TS werden im Head-End 4 nicht direkt dekomprimiert und/oder ausgewertet, sondern zunächst in Speichermitteln 50 des Head Ends 4 gespeichert. Die Verbrauchsdaten werden an die Auswertemittel 18 des Head-Ends 4 weiter geleitet. Sofern zu einem späteren Zeitpunkt ein Bedarf für die Zeitstempelungen TS besteht, werden diese dekomprimiert und/oder ausgewertet. Beispielsweise könnte ein Alarm, ein Fehler, eine Störung oder dergleichen an einem der Verbrauchszähler 10a - 10c detektiert werden. In Fig. 10 wird beispielsweise ein Alarm bei Verbrauchszähler 10b detektiert. Das Head-End 4 ist in der Lage, die gespeicherten Zeitstempelungen TS im Zeitstempelung-Telegramm 17b des Verbrauchszählers 10b zu dekomprimieren und/oder auszuwerten und einen Rohmessdatenstrom 13b zu erzeugen, welcher den Auswertemitteln 18 zugeleitet wird. Die detaillierten Informationen, die der Rohmessdatenstrom 13b liefert, werden für die Analyse des Verhaltens des Verbrauchszählers 10b verwendet.

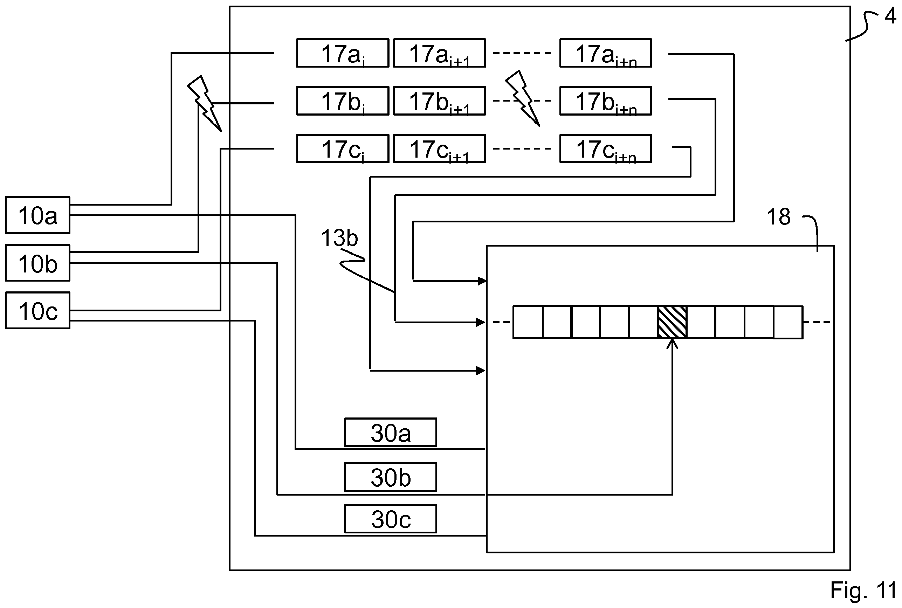

In einer weiteren Ausgestaltung gemäß Fig. 11 werden die Verbrauchsdaten verwendet, um fehlende oder fehlerhafte Zeitstempelungen TS zu ergänzen. Fig. 11 zeigt beispielhaft drei Verbrauchszähler 10a, 10b und 10c, welche jeweils Zeitstempelung-Telegramme 17a, 17b und 17c sowie Verbrauchsdaten-Telegramme 30a, 30b und 30c an das Head End 4 übertragen. Beispielsweise fehlen Zeitstempelung-Telegramme 17b des Verbrauchszählers 10b, was z. B. durch eine Störung in der Übertragung vom Verbrauchszähler 10b zum Head-End 4 verursacht worden ist. Aufgrund der fehlenden Zeitstempelungen TS kann das Head-End 4 den Rohmessdatenstrom 13b in den Auswertemitteln 18 nicht korrekt auswerten. Die Verbrauchsdaten aus den Verbrauchsdaten-Telegrammen 30b des Verbrauchszählers 10b können verwendet werden, um die fehlenden Zeitstempelungen TS zu identifizieren. Ferner können die Verbrauchsdaten für einen Reset der Verbrauchszählerfunktionen dienen. Anschließend können neue Berechnungen ausgehenden von den aktuellen Verbrauchsdaten begonnen werden.

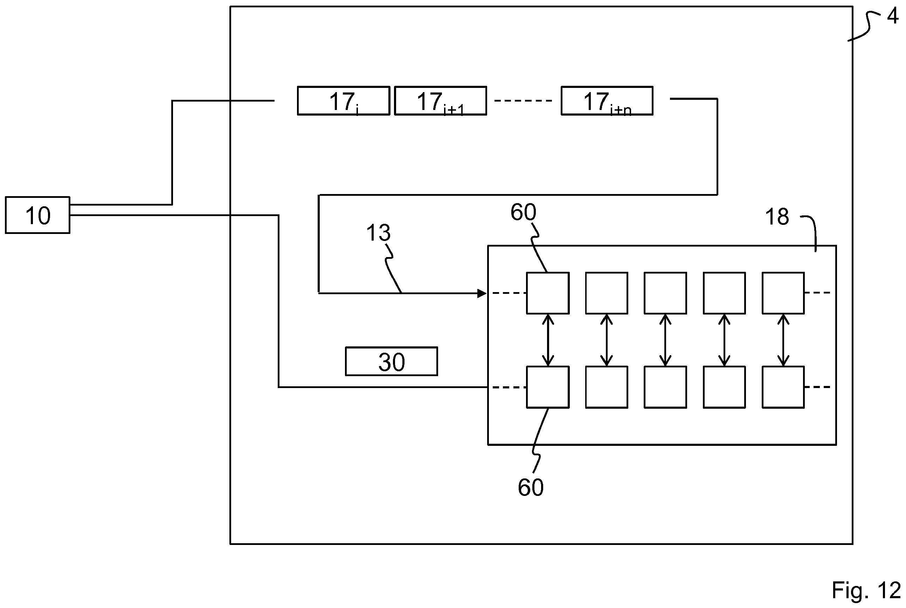

Ferner besteht die Möglichkeit einer Ausgestaltung gemäß Fig. 12. Hier ist beispielhaft ein Verbrauchszähler 10, welcher Zeitstempelung-Telegramme 17 sowie Verbrauchsdaten-Telegramme 30 an das Head End 4 überträgt, gezeigt. Die Verbrauchsdaten umfassen hierbei einen absoluten Zählerindex 60 zu einem bestimmten Zeitpunkt, z. B. ein Fälligkeitsdatum, welches vom Verbrauchszähler 10 bereitgestellt wird. Die Zeitstempelungen TS werden andererseits im Head-End 4 verwendet, um den absoluten Zählerindex 60 zu einem bestimmten Zeitpunkt zu berechnen, z. B ein Fälligkeitsdatum, welches vom Head-End 4 bereitgestellt wird. Diese beiden absoluten Zählerindizes 60 werden für eine Konsistenzkontrolle verwendet, indem diese verglichen werden. Für einen bestimmten Zeitpunkt müssen beide absoluten Zählerindizes 60 identisch sein. Andernfalls deutet dies auf eine Diskrepanz in den Messverfahren hin, weshalb Maßnahmen zur Korrektur unternommen werden müssen.

Mit dem erfindungsgemäßen Verfahren können somit beliebige Rohmessdaten abgetastet und als Auslöser für Zeitstempelungen TS verwendet werden. Bei den Zeitstempelungen TS kann es sich insbesondere um Zeitpunkte oder Zeitdifferenzen handeln. Vorzugsweise ist ein Startzeitpunkt definiert.

Vorzugsweise werden die Zeitstempelungen TS in den Speichermitteln 7 des Verbrauchszählers 10 erst dann gelöscht, wenn die Übertragung der Zeitstempelungen TS über die primäre Kommunikationsstrecke 5 vom Empfänger bzw. Datensammler 3 bestätigt worden ist.

Der Fachmann versteht selbstverständlich, dass die Erfindung auf die Messung und Fernauslesung verschiedenster Parameter und Größen angewendet werden kann: Es genügt, eine elementare (vom Sensor 1 messbare) Veränderung eines Parameters oder einer Größe in Übereinstimmung mit der Auflösung des betrachteten Sensors 1 genau datieren zu können (die zeitgestempelte elementare Variation kann der Auflösung des Sensors oder möglicherweise einem Vielfachen dieser Auflösung entsprechen).

Selbstverständlich ist die Erfindung nicht auf die in den beigefügten Zeichnungen beschriebenen und dargestellten Ausführungsformen beschränkt. Änderungen bleiben möglich, insbesondere hinsichtlich der Beschaffung der verschiedenen Elemente oder durch technische Entsprechungen, ohne dass dadurch der Schutzbereich der Erfindung verlassen wird. Vom Gegenstand der Offenbarung umfasst, sind ausdrücklich auch Kombinationen von Teilmerkmalen oder Untergruppen von Merkmalen untereinander. Der Schutzbereich der Erfindung wird durch die folgenden Ansprüche definiert.

### BEZUGSZEICHENLISTE

- 1: Sensor
- 2: Kommunikationsmittel
- 3: Datensammler
- 4: Head-End
- 5: primäre Kommunikationsstrecke
- 6: tertiäre Kommunikationsstrecke
- 7: Speichermittel
- 8: Mikroprozessor
- 9: Messelement
- 10: Verbrauchszähler
- 11: Funkstrecke
- 13: Rohmessdatenstrom
- 14: Messdatenaufbereitung
- 15: Zeitreferenzeinrichtung
- 16: Versorgungsleitung
- 17: Zeitstempelung-Telegramm
- 18: Auswertemittel
- 19: Impulsgeberelement
- 20: Flügelrad
- 30: Verbrauchsdaten-Telegramm
- 40: mobiles Auslesemodul
- 50: Speichermittel (Head-End)
- 60: absoluter Zählerindex

- PAⱼ: Datenpaket
- TS: Zeitstempelung

## Patentansprüche

1. Verfahren zum Sammeln von Daten in Zusammenhang mit einem Verbrauch, einem physikalischen oder physikalisch-chemischen Parameter und/oder einem Betriebszustand im Rahmen eines Betriebs eines lokalen Sensors (1), vorzugsweise eines Sensors (1) für einen Verbrauchszähler (10), als Bestandteil eines mindestens einen lokalen Sensor (1) vorzugsweise eine Mehrzahl von lokalen Sensoren (1) umfassendes Versorgungsnetzes zur Verteilung eines Verbrauchsguts, wobei
der Sensor (1) ein Messelement (9) enthält,
das Messelement (9) des jeweiligen Sensors (1) elementare Messeinheiten, die mindestens einer physikalischen oder physikalisch-chemischen Größe oder mindestens einem physikalischen oder physikalisch-chemischen Parameter entsprechen, als Rohmessdaten liefert,
Verbrauchsdaten aus den elementaren Messeinheiten erzeugt werden und
der Sensor (1) Kommunikationsmittel (2) sowie Speichermittel (7) umfasst, wobei
zur Festlegung der Messauflösung des Sensors (1) die Bedingungen für ein Generieren von Zeitstempelungen (TS) unter Anwendung eines Korrelierungsmodells vorher festgelegt werden,
auf der Basis des Korrelierungsmodells Zeitstempelungen (TS) von aufeinanderfolgenden Rohmessdaten in dem Sensor (1) generiert werden,
die Zeitstempelungen (TS) über eine drahtgebundene Verbindung und/oder über eine Funkstrecke übertragen werden, so dass auf Basis der Zeitstempelungen (TS) unter Anwendung des Korrelierungsmodells die vom Messelement (9) erfassten Rohmessdaten rekonstruiert und ausgewertet werden, und wobei
der Sensor (1) über eine primäre Kommunikationsstrecke (5) mit einem Datensammler (3) in Verbindung steht,
zwischen dem Datensammler (3) und einem Head-End (4) eine tertiäre Kommunikationsstrecke (6) vorgesehen ist, und
die von dem Sensor (1) übertragenen Zeitstempelungen (TS) im Datensammler (3) und/oder im Head-End (4) gesammelt, gespeichert und/oder ausgewertet werden, **dadurch gekennzeichnet, dass**
die Zeitstempelungen (TS) und die Verbrauchsdaten parallel über verschiedene Funkstrecken übertragen werden,
eine Mehrzahl von Zeitstempelungen (TS) entlang der primären Kommunikationsstrecke (5) jeweils als Datenpaket (17ᵢ, 17ᵢ₊ₙ) übertragen wird, wobei ein Datenpaket jeweils mehrere Zeitstempelungen (TS1-TSn) enthält und
die Festlegung, wann eine Datenübertragung vom Sensor (1) durchzuführen ist, davon abhängt, ob eine vorgegebenen Menge an insbesondere komprimierten gesammelten Zeitstempelungen (TS) seit der vorherigen Datenübertragung erreicht ist.

2. Verfahren nach Anspruch 1
**dadurch gekennzeichnet,**
**dass** im Rahmen des Korrelierungsmodells ein bestimmter Wert, eine bestimmte Wertänderung oder eine bestimmte Wertdifferenz der mindestens einen physikalischen oder physikalisch-chemischen Größe oder des mindestens einen physikalischen oder physikalisch-chemischen Parameters für die Zuordnung einer Zeitstempelung (TS) festgelegt wird,
bei einem Erfassen des bestimmten Werts, der bestimmten Wertänderung oder der bestimmten Wertdifferenz durch das Messelement (9) eine Zeitstempelung (TS) ausgelöst und in den Speichermitteln (7) des Sensors (1) abgespeichert wird.

3. Verfahren nach einem der vorhergehenden Ansprüche, **dadurch gekennzeichnet, dass** im Rahmen des Korrelierungsmodells ein schrittweise oder inkrementell sich erhöhender Zählerstand und/oder eine Wertetabelle mittels Zeitstempelungen (TS) abgebildet wird.

4. Verfahren nach einem der vorhergehenden Ansprüche, **dadurch gekennzeichnet, dass** die Zeitstempelungen (TS) mit einem Vorzeichen versehen sind.

5. Verfahren nach einem der vorhergehenden Ansprüche, **dadurch gekennzeichnet, dass** auf Basis der beim Datensammler (3) und/oder beim Head-End (4) ankommenden Zeitstempelungen (TS) unter Anwendung des Korrelierungsmodells ein Rohmessdatenstrom (13) generiert wird.

6. Verfahren nach einem der vorhergehenden Ansprüche, **dadurch gekennzeichnet, dass** die Zeitstempelungen (TS) komprimiert werden und die Komprimierung der Zeitstempelungen (TS) verlustfrei durchgeführt wird oder die Komprimierung der Zeitstempelungen (TS) mit einem vorgegebenen zulässigen Verlustniveau durchgeführt wird.

7. Verfahren nach einem der vorhergehenden Ansprüche, **dadurch gekennzeichnet, dass** die Verbrauchsdaten nicht komprimiert werden.

8. Verfahren nach einem der vorhergehenden Ansprüche, **dadurch gekennzeichnet, dass** die Verbrauchsdaten an ein mobiles Auslesemodul (40) gesendet werden und die Zeitstempelungen (TS) über eine primäre Kommunikationsstrecke (5) an einen Datensammler (3) gesendet werden.

9. Verfahren nach einem der vorhergehenden Ansprüche, **dadurch gekennzeichnet, dass** die Verbrauchsdaten und die Zeitstempelungen (TS) kombiniert werden.

10. Verfahren nach einem der Ansprüche 6 bis 9, **dadurch gekennzeichnet, dass** die komprimierten Zeitstempelungen (TS) im Head-End (4) gespeichert werden und bei Bedarf dekomprimiert werden.

11. Verfahren nach einem der vorhergehenden Ansprüche, **dadurch gekennzeichnet, dass** die Verbrauchsdaten verwendet werden, um fehlende und/oder fehlerhafte Zeitstempelungen (TS) zu kompensieren, und/oder die Verbrauchsdaten und die Zeitstempelungen (TS) verglichen werden, um eine Konsistenzkontrolle durchzuführen.

12. Verfahren nach einem der vorhergehenden Ansprüche, **dadurch gekennzeichnet, dass** der Rohmessdatenstrom (13) in der Weiterfolge der Datenverarbeitung abgesehen von der Messauflösung des Sensors (1) auf einer zeithistorischen Basis zeitlückenlos auswertbar ist.

13. Verfahren nach einem der vorhergehenden Ansprüche, **dadurch gekennzeichnet, dass** es sich bei den elementaren Messeinheiten um die elektrische Spannung oder um die Stromstärke handelt.

14. Verfahren nach einem der vorhergehenden Ansprüche, **dadurch gekennzeichnet, dass** die gemessene physikalische Größe sich auf ein Versorgungsmedium, vorzugsweise Wasser, Strom, Treibstoff oder Gas, eines Versorgungsnetzes bezieht und/oder der oder einer der gemessene(n) physikalische(n) oder chemisch-physikalische(n) Parameter kennzeichnend ist für die Menge, die Qualität und/oder Zusammensetzung eines Fluids, das durch den betreffenden Sensor (1) strömt oder von diesem kontaktiert wird.

15. Verfahren nach einem der vorhergehenden Ansprüche, **dadurch gekennzeichnet, dass** die elementare Messeinheit (9) eine Zeitstempelung (TS) generiert, sobald die elementare Messeinheit (9) einen Impuls empfängt.

16. Verfahren nach einem der vorhergehenden Ansprüche, **dadurch gekennzeichnet, dass** der Rohmessdatenstrom (13) eine zeitliche Auflösung besitzt, die durch die Sensor-Abtastrate bzw. Messelement-Abtastrate oder ein Vielfaches derselben festgelegt oder bedingt ist.

17. Verfahren nach einem der vorhergehenden Ansprüche, **dadurch gekennzeichnet, dass** der Rohmessdatenstrom (13) unter Zugrundelegung einer stetigen zeitlichen Auflösung kontinuierlich und/oder vollständig ist.

18. Verfahren nach einem der vorhergehenden Ansprüche, **dadurch gekennzeichnet, dass** die Festlegung, wann eine Datenübertragung vom Sensor durchzuführen ist, ferner vom Ablauf eines vorgegebenen Zeitintervalls abhängt.

19. Verfahren nach einem der vorhergehenden Ansprüche, **dadurch gekennzeichnet, dass** es umfasst, die Zeitstempelungen (TS) durch Formatierung in Datenpaketen (PAⱼ) vorbestimmter fester Größe zu verpacken, wobei jedes Mal, wenn die akkumulierten Daten die Größe eines Datenpakets (PAⱼ) erreichen oder das vorgegebene Zeitintervall abgelaufen ist, eine neue Übertragung ausgelöst wird.

20. Verfahren nach einem der vorhergehenden Ansprüche, **dadurch gekennzeichnet, dass** die Datenübertragung mit einer Redundanz durchgeführt wird, wobei die Redundanz in der Übertragung insbesondere durch wiederholtes Senden derselben Zeitstempelungen (TS) und/oder wiederholtes Senden desselben Datenpakets (PAⱼ) in mehreren aufeinanderfolgenden Übertragungsvorgängen erreicht wird.

21. Sensor (1) zum Sammeln von Daten in Zusammenhang mit einem Verbrauch, einem physikalischen oder physikalisch-chemischen Parameter und/oder einem Betriebszustand im Rahmen eines Betriebs eines lokalen Sensors, vorzugsweise für einen Verbrauchszähler (10), als Bestandteil eines mindestens einen lokalen Sensor (1) vorzugsweise eine Mehrzahl von lokalen Sensoren (1) umfassendes Versorgungsnetzes zur Verteilung eines Verbrauchsguts, wobei
der Sensor (1) ein Messelement (9) enthält,
das Messelement (9) des jeweiligen Sensors (1) elementare Messeinheiten, die mindestens einer physikalischen oder physikalisch-chemischen Größe oder mindestens eines physikalischen oder physikalisch-chemischen Parameters entsprechen, als Rohmessdaten liefert,
der Sensor (1) Kommunikationsmittel (2) sowie Speichermittel (7) umfasst, wobei der Sensor (1) dazu eingerichtet ist,
Verbrauchsdaten aus den elementaren Messeinheiten zu erzeugen,
zur Festlegung der Messauflösung des Sensors (1) die Bedingungen für ein Generieren von Zeitstempelungen (TS) unter Anwendung eines Korrelierungsmodells vorher festzulegen,
auf der Basis des Korrelierungsmodells Zeitstempelungen (TS) von aufeinanderfolgenden Rohmessdaten in dem Sensor (1) zu generieren,
die Zeitstempelungen (TS) über eine drahtgebundene Verbindung und/ oder über eine Funkstrecke zu übertragen wobei
der Sensor (1) über eine primäre Kommunikationsstrecke (5) mit einem über eine tertiäre Kommunikationsstrecke (6) verbindbaren Datensammler (3) verbindbar ist, **dadurch gekennzeichnet, dass**
der Sensor dazu eingerichtet ist, die Verbrauchsdaten parallel zu den Zeitstempelungen (TS) über verschiedene Funkstrecken zu übertragen,
eine Mehrzahl von Zeitstempelungen (TS) entlang der primären Kommunikationsstrecke (5) jeweils als Datenpaket (17ᵢ, 17ᵢ₊ₙ) zu übertragen, wobei ein Datenpaket jeweils mehrere Zeitstempelungen (TS1-TSn) enthält, und
die Festlegung, wann eine Datenübertragung erfolgen soll oder nicht, davon abhängig zu machen, ob eine vorgegebenen Menge an insbesondere komprimierten gesammelten Zeitstempelungen(TS) seit der vorherigen Datenübertragung erreicht ist.

22. Messdaten-Informationsnetzwerk zur Verteilung eines Verbrauchsguts mit mindestens einem lokalen Sensor (1) vorzugsweise einer Mehrzahl von lokal angeordneten Sensoren (1) zum Generieren und/oder Weiterleiten von Zeitstempelungen (TS) von Rohmessdaten auf der Basis des Korrelierungsmodells, vorzugsweise Rohmessdaten in Zusammenhang mit einem Verbrauch an Verbrauchsmedium, einem physikalischen oder physikalisch-chemischen Parameter und/oder einem Betriebszustand eines Verbrauchszählers (10), deren Messwerte in einem Head-End (4) ausgewertet werden, **dadurch gekennzeichnet, dass** als Sensor ein Sensor (1) nach Anspruch 21 vorgesehen ist.

23. Messdaten-Informationsnetzwerk nach Anspruch 22, **dadurch gekennzeichnet, dass** ein im Head-End (4) auszuwertender Rohmessdatenstrom (13) unter Zugrundelegung einer stetigen zeitlichen Auflösung kontinuierlich und/oder vollständig ist.

## Claims

1. Method for collecting data in connection with a consumption, a physical or physico-chemical parameter and/or an operating state during operation of a local sensor (1), preferably a sensor (1) for a consumption meter (10), as part of a supply network which comprises at least one local sensor (1), preferably a plurality of local sensors (1), and is intended to distribute a consumable, wherein
the sensor (1) contains a measuring element (9),
the measuring element (9) of the respective sensor (1) provides elementary measuring units, which correspond to at least one physical or physico-chemical variable or at least one physical or physico-chemical parameter, as raw measurement data,
consumption data are generated from the elementary measuring units, and
the sensor (1) comprises communication means (2) and storage means (7), wherein
in order to determine the measurement resolution of the sensor (1), the conditions for generating time stamps (TS) are determined in advance using a correlation model,
time stamps (TS) of successive raw measurement data are generated in the sensor (1) on the basis of the correlation model,
the time stamps (TS) are transmitted via a wired connection and/or via a radio path, with the result that the raw measurement data acquired by the measuring element (9) are reconstructed and evaluated on the basis of the time stamps (TS) using the correlation model, and wherein
the sensor (1) is connected to a data collector (3) via a primary communication path (5),
a tertiary communication path (6) is provided between the data collector (3) and a head end (4), and
the time stamps (TS) transmitted by the sensor (1) are collected, stored and/or evaluated in the data collector (3) and/or in the head end (4), **characterized in that**
the time stamps (TS) and the consumption data are transmitted in a parallel manner via different radio paths,
a plurality of time stamps (TS) are each transmitted as a data packet (17ᵢ, 17ᵢ₊ₙ) along the primary communication path (5), wherein a data packet respectively contains a plurality of time stamps (TS1-TSn), and
the determination of when a data transmission should be carried out by the sensor (1) depends on whether a predefined quantity of in particular compressed collected time stamps (TS) since the previous data transmission has been reached.

2. Method according to Claim 1, **characterized in that** a particular value, a particular value change or a particular value difference of the at least one physical or physico-chemical variable or the at least one physical or physico-chemical parameter is determined within the scope of the correlation model for the assignment of a time stamp (TS),
if the particular value, the particular value change or the particular value difference is captured by the measuring element (9), a time stamp (TS) is triggered and is stored in the storage means (7) of the sensor (1).

3. Method according to one of the preceding claims, **characterized in that** a gradually or incrementally increasing meter reading and/or a value table is/are represented by means of time stamps (TS) within the scope of the correlation model.

4. Method according to one of the preceding claims, **characterized in that** the time stamps (TS) are provided with a sign.

5. Method according to one of the preceding claims, **characterized in that** a raw measurement data stream (13) is generated on the basis of the time stamps (TS) arriving at the data collector (3) and/or at the head end (4) using the correlation model.

6. Method according to one of the preceding claims, **characterized in that** the time stamps (TS) are compressed and the compression of the time stamps (TS) is carried out in a loss-free manner or the compression of the time stamps (TS) is carried out with a predefined permissible loss level.

7. Method according to one of the preceding claims, **characterized in that** the consumption data are not compressed.

8. Method according to one of the preceding claims, **characterized in that** the consumption data are transmitted to a mobile readout module (40) and the time stamps (TS) are transmitted to a data collector (3) via a primary communication path (5).

9. Method according to one of the preceding claims, **characterized in that** the consumption data and the time stamps (TS) are combined.

10. Method according to one of Claims 6 to 9, **characterized in that** the compressed time stamps (TS) are stored in the head end (4) and decompressed if necessary.

11. Method according to one of the preceding claims, **characterized in that** the consumption data are used to compensate for missing and/or incorrect time stamps (TS), and/or the consumption data and the time stamps (TS) are compared in order to carry out a consistency check.

12. Method according to one of the preceding claims, **characterized in that** the raw measurement data stream (13) can be evaluated, in the further course of the data processing, on a time-historical basis without a time gap irrespective of the measurement resolution of the sensor (1) .

13. Method according to one of the preceding claims, **characterized in that** the elementary measuring units are the electrical voltage or the current intensity.

14. Method according to one of the preceding claims, **characterized in that** the measured physical variable relates to a supply medium, preferably water, electricity, fuel or gas, of a supply network and/or the or one of the measured physical or chemico-physical parameter(s) is characteristic of the quantity, quality and/or composition of a fluid which flows through the relevant sensor (1) or with which contact is made by the latter.

15. Method according to one of the preceding claims, **characterized in that** the elementary measuring unit (9) generates a time stamp (TS) as soon as the elementary measuring unit (9) receives a pulse.

16. Method according to one of the preceding claims, **characterized in that** the raw measurement data stream (13) has a temporal resolution that is determined or conditioned by the sensor sampling rate or measuring element sampling rate or a multiple thereof.

17. Method according to one of the preceding claims, **characterized in that** the raw measurement data stream (13) is continuous and/or complete taking a continuous temporal resolution as a basis.

18. Method according to one of the preceding claims, **characterized in that** the determination of when a data transmission should be carried out by the sensor also depends on the expiry of a predefined interval of time.

19. Method according to one of the preceding claims, **characterized in that** it comprises packaging the time stamps (TS) by formatting them in data packets (PAⱼ) of a predetermined fixed size, wherein, each time the accumulated data reach the size of a data packet (PAⱼ) or the predefined interval of time has expired, a new transmission is initiated.

20. Method according to one of the preceding claims, **characterized in that** the data transmission is carried out with redundancy, wherein the redundancy in the transmission is achieved, in particular, by repeatedly transmitting the same time stamps (TS) and/or repeatedly transmitting the same data packet (PAⱼ) in a plurality of successive transmission operations.

21. Sensor (1) for collecting data in connection with a consumption, a physical or physico-chemical parameter and/or an operating state during operation of a local sensor, preferably for a consumption meter (10), as part of a supply network which comprises at least one local sensor (1), preferably a plurality of local sensors (1), and is intended to distribute a consumable, wherein
the sensor (1) contains a measuring element (9),
the measuring element (9) of the respective sensor (1) provides elementary measuring units, which correspond to at least one physical or physico-chemical variable or at least one physical or physico-chemical parameter, as raw measurement data,
the sensor (1) comprises communication means (2) and storage means (7), wherein the sensor (1) is configured
to generate consumption data from the elementary measuring units,
to determine in advance the conditions for generating time stamps (TS) using a correlation model in order to determine the measurement resolution of the sensor (1),
to generate time stamps (TS) of successive raw measurement data in the sensor (1) on the basis of the correlation model,
to transmit the time stamps (TS) via a wired connection and/or via a radio path, wherein
the sensor (1) can be connected to a data collector (3), which can be connected via a tertiary communication path (6), via a primary communication path (5), **characterized in that**
the sensor is configured to transmit the consumption data in parallel with the time stamps (TS) via different radio paths,
to respectively transmit a plurality of time stamps (TS) as a data packet (17ᵢ, 17ᵢ₊ₙ) along the primary communication path (5), wherein a data packet respectively contains a plurality of time stamps (TS1-TSn), and
to make the determination of when a data transmission should be carried out or not dependent on whether a predefined quantity of in particular compressed collected time stamps (TS) since the previous data transmission has been reached.

22. Measurement data information network for distributing a consumable, having
at least one local sensor (1), preferably a plurality of locally arranged sensors (1), for generating and/or forwarding time stamps (TS) of raw measurement data on the basis of the correlation model, preferably raw measurement data in connection with a consumption of consumption medium, a physical or physico-chemical parameter and/or an operating state of a consumption meter (10), the measured values from which are evaluated in a head end (4), **characterized in that** a sensor (1) according to Claim 21 is provided as the sensor.

23. Measurement data information network according to Claim 22, **characterized in that** a raw measurement data stream (13) to be evaluated in the head end (4) is continuous and/or complete taking a continuous temporal resolution as a basis.

## Revendications

1. Procédé de collecte de données en relation avec une consommation, un paramètre physique ou physico-chimique et/ou un état de fonctionnement dans le cadre d'un fonctionnement d'un capteur local (1), de préférence d'un capteur (1) destiné à un compteur de consommation (10), en tant que partie d'un réseau d'approvisionnement qui comprend au moins un capteur local (1), de préférence une pluralité de capteurs locaux (1), et qui est destiné à distribuer un bien de consommation,
le capteur (1) contenant un élément de mesure (9), l'élément de mesure (9) du capteur (1) respectif fournissant comme données de mesure brutes des unités de mesure élémentaires qui correspondent à au moins une grandeur physique ou physico-chimique ou à au moins un paramètre physique ou physico-chimique,
des données de consommation étant générées à partir des unités de mesure élémentaires et
le capteur (1) comprenant des moyens de communication (2) et des moyens de stockage (7),
les conditions de génération d'horodatages (TS) étant définies au préalable à l'aide d'un modèle de corrélation afin de définir la résolution de mesure du capteur (1),
des horodatages (TS) de données de mesure brutes successives étant générés dans le capteur (1) sur la base du modèle de corrélation,
les horodatages (TS) étant transmis par une liaison filaire et/ou par une liaison radioélectrique de sorte que les données de mesure brutes acquises par un élément de mesure (9) soient reconstruites et évaluées sur la base des horodatages (TS) à l'aide du modèle de corrélation, et
le capteur (1) étant relié à un collecteur de données (3) par le biais d'une liaison de communication primaire (5),
une liaison de communication tertiaire (6) étant prévue entre le collecteur de données (3) et une tête de réseau (4), et
les horodatages (TS) transmis par le capteur (1) étant collectés, stockés et/ou évalués dans le collecteur de données (3) et/ou dans la tête de réseau (4), **caractérisé en ce que**
les horodatages (TS) et les données de consommation sont transmis en parallèle par différentes liaisons radioélectriques,
une pluralité d'horodatages (TS) sont transmis sur la liaison de communication primaire (5) sous la forme d'un paquet de données (17ᵢ, 17ᵢ₊ₙ), un paquet de données contenant plusieurs horodatages (TS1-TSn) et
la définition du moment où une transmission de données doit être effectuée par le capteur (1) dépend du fait qu'une quantité spécifiée d'horodatages (TS) collectés, en particulier compressés, a été atteinte depuis la transmission de données précédente.

2. Procédé selon la revendication 1, **caractérisé en ce que**, dans le cadre du modèle de corrélation, une valeur spécifique, une variation de valeur déterminée ou une différence de valeur déterminée de l'au moins une grandeur physique ou physico-chimique ou de l'au moins un paramètre physique ou physico-chimique est définie pour l'association d'un horodatage (TS), lorsque la valeur déterminée, la variation de valeur déterminée ou la différence de valeur déterminée est acquise par l'élément de mesure (9), un horodatage (TS) est déclenché et stocké dans les moyens de stockage (7) du capteur (1).

3. Procédé selon l'une des revendications précédentes, **caractérisé en ce que**, dans le cadre du modèle de corrélation, une indication de compteur augmentant pas à pas ou par incrément et/ou un tableau de valeurs sont reproduits à l'aide d'horodatages (TS).

4. Procédé selon l'une des revendications précédentes, **caractérisé en ce que** les horodateurs (TS) sont munis d'un signe.

5. Procédé selon l'une des revendications précédentes, **caractérisé en ce qu'**un flux de données de mesure brutes (13) est généré à l'aide du modèle de corrélation sur la base des horodatages (TS) arrivant au collecteur de données (3) et/ou à la tête de réseau (4) .

6. Procédé selon l'une des revendications précédentes, **caractérisé en ce que** les horodatages (TS) sont compressés et la compression des horodatages (TS) est effectuée sans perte ou la compression des horodatages (TS) est effectuée avec un niveau de perte admissible spécifié.

7. Procédé selon l'une des revendications précédentes, **caractérisé en ce que** les données de consommation ne sont pas compressées.

8. Procédé selon l'une des revendications précédentes, **caractérisé en ce que** les données de consommation sont envoyées à un module de lecture mobile (40) et les horodatages (TS) sont envoyés à un collecteur de données (3) par le biais d'une liaison de communication primaire (5).

9. Procédé selon l'une des revendications précédentes, **caractérisé en ce que** les données de consommation et les horodatages (TS) sont combinés.

10. Procédé selon l'une des revendications 6 à 9, **caractérisé en ce que** les horodateurs (TS) compressés sont stockés dans la tête de réseau (4) et sont décompressés si nécessaire.

11. Procédé selon l'une des revendications précédentes, **caractérisé en ce que** les données de consommation sont utilisées pour compenser des horodatages (TS) manquants et/ou incorrects, et/ou les données de consommation et les horodatages (TS) sont comparés afin d'effectuer un contrôle de cohérence.

12. Procédé selon l'une des revendications précédentes, **caractérisé en ce que** le flux de données de mesure brutes (13) peut être évalué sans aucun intervalle de temps sur une base historique dans la suite du traitement des données, à l'exception de la résolution de mesure du capteur (1).

13. Procédé selon l'une des revendications précédentes, **caractérisé en ce que** les unités de mesure élémentaires sont la tension électrique ou l'intensité du courant.

14. Procédé selon l'une des revendications précédentes, **caractérisé en ce que** la grandeur physique mesurée concerne un milieu d'alimentation, de préférence de l'eau, un courant, un carburant ou un gaz, d'un réseau d'alimentation et/ou le paramètre physique ou physico-chimique ou l'un des paramètres physiques ou physico-chimiques, caractéristiques de la quantité, de la qualité et/ou de la composition d'un fluide qui traverse le capteur (1) concerné ou qui entre en contact avec celui-ci.

15. Procédé selon l'une des revendications précédentes, **caractérisé en ce que** l'unité de mesure élémentaire (9) génère un horodatage (TS) dès que l'unité de mesure élémentaire (9) reçoit une impulsion.

16. Procédé selon l'une des revendications précédentes, **caractérisé en ce que** le flux de données de mesure brutes (13) a une résolution temporelle qui est définie ou conditionnée par la fréquence d'échantillonnage du capteur ou de l'élément de mesure ou un multiple de celle-ci.

17. Procédé selon l'une des revendications précédentes, **caractérisé en ce que** le flux de données de mesure brutes (13) est continu et/ou complet sur la base d'une résolution temporelle constante.

18. Procédé selon l'une des revendications précédentes, **caractérisé en ce que** la définition du moment où une transmission de données doit être effectuée par le capteur dépend également de l'expiration d'un intervalle de temps spécifié.

19. Procédé selon l'une des revendications précédentes, **caractérisé en ce qu'**il comprend le conditionnement des horodatages (TS) par formatage en paquets de données (PAⱼ) d'une taille fixe prédéterminée, une nouvelle transmission étant déclenchée chaque fois que les données accumulées atteignent la taille d'un paquet de données (PAⱼ) ou que l'intervalle de temps spécifié a expiré.

20. Procédé selon l'une des revendications précédentes, **caractérisé en ce que** la transmission des données est effectuée avec redondance, la redondance dans la transmission étant obtenue notamment par l'envoi répété des mêmes horodatages (TS) et/ou par l'envoi répété du même paquet de données (PAⱼ) dans plusieurs processus de transmission successifs.

21. Capteur (1) destiné à collecter des données en relation avec une consommation, un paramètre physique ou physico-chimique et/ou un état de fonctionnement dans le cadre d'un fonctionnement d'un capteur local, de préférence d'un capteur (1) destiné à un compteur de consommation (10), en tant que partie d'un réseau d'approvisionnement qui comprend au moins un capteur local (1), de préférence une pluralité de capteurs locaux (1), et qui est destiné à distribuer un bien de consommation,
le capteur (1) contenant un élément de mesure (9), l'élément de mesure (9) du capteur (1) respectif fournissant comme données de mesure brutes des unités de mesure élémentaires qui correspondent à au moins une grandeur physique ou physico-chimique ou à au moins un paramètre physique ou physico-chimique,
le capteur (1) comprenant des moyens de communication (2) et des moyens de stockage (7), le capteur (1) étant conçu
pour générer des données de consommation à partir des unités de mesure élémentaires et
pour définir au préalable les conditions de génération d'horodatages (TS) à l'aide d'un modèle de corrélation afin de définir la résolution de mesure du capteur (1), pour générer des horodatages (TS) de données de mesure brutes successives dans le capteur (1) sur la base du modèle de corrélation,
pour transmettre les horodatages (TS) par une liaison filaire et/ou par une liaison radioélectrique, et
le capteur (1) pouvant être relié par le biais d'une liaison de communication primaire (5) à un collecteur de données (3) qui peut être relié par le biais d'une liaison de communication tertiaire (6), **caractérisé en ce que**
le capteur est conçu
pour transmettre les données de consommation parallèlement aux horodatages (TS) par différentes liaisons radioélectriques,
pour transmettre une pluralité d'horodatages (TS) sur la liaison de communication primaire (5) sous la forme d'un paquet de données (17ᵢ, 17ᵢ₊ₙ), un paquet de données contenant plusieurs horodatages (TS1-TSn) et
pour faire en sorte que la définition du moment où une transmission de données doit être effectuée dépende du fait qu'une quantité spécifiée d'horodatages (TS) collectés, en particulier compressés, a été atteinte depuis la transmission de données précédente.

22. Réseau d'informations de données de mesure destiné à distribuer un bien de consommation et comprenant au moins un capteur local (1), de préférence une pluralité de capteurs disposés localement (1), générer et/ou transmettre des horodatages (TS) de données de mesure brutes sur la base du modèle de corrélation, de préférence des données de mesure brutes en relation avec une consommation de milieu de consommation, un paramètre physique ou physico-chimique et/ou un état de fonctionnement d'un compteur de consommation (10), dont les valeurs de mesure sont évaluées dans une tête de réseau (4), **caractérisé en ce que** le capteur est un capteur (1) selon la revendication 21.

23. Réseau d'informations de données de mesure selon la revendication 22, **caractérisé en ce qu'**un flux de données de mesure brutes (13) à évaluer dans la tête de réseau (4) est continu et/ou complet sur la base d'une résolution temporelle constante.
